# EUROPEAN PATENT APPLICATION

(11) **EP 4 586 757 A1**
(43) Date of publication of application: **16.07.2025**
(21) Application number: 24210487.5
(22) Date of filing: 04.11.2024
(51) Int. Cl.: H10B 12/00, H10D 30/67

(54) **SEMICONDUCTOR MEMORY DEVICE**

(30) Priority: 15.01.2024 KR 20240006241
(71) Applicant: Samsung Electronics Co., Ltd., Suwon-si, Gyeonggi-do 16677 (KR)
(72) Inventor: HORII, Hideki, 16677 Suwon-si (KR); YOON, Minseo, 16677 Suwon-si (KR); CHUNG, Sukhwan, 16677 Suwon-si (KR); CHOI, Jin Myung, 16677 Suwon-si (KR)
(74) Representative: Marks & Clerk LLP

(57) **Abstract**

A semiconductor memory device includes a bit line, a word line, first and second mold dielectric patterns overlapping the bit line and extending parallel to the word line, the first and second mold dielectric patterns vertically stacked on each other, a first metal oxide pattern disposed between the word line and a top surface of the bit line and between the word line and a lateral surface of the first mold dielectric pattern, a second metal oxide pattern contacting a lateral surface of the second mold dielectric pattern, and a channel pattern disposed between the first metal oxide pattern and the word line and contacting a bottom surface of each of the second mold dielectric pattern and the second metal oxide pattern.

## Description

### BACKGROUND

The present inventive concepts relate to a semiconductor memory device, and more particularly, to a semiconductor memory device including vertical channel transistors and a method of fabricating the same.

With the trend of reducing design rules in semiconductor memory devices, fabrication technology is being improved to increase a level of integration, an operating speed, and a fabrication yield of the semiconductor memory devices. Accordingly, transistors with vertical channels have been suggested to increase their integration level, current driving capability of transistors, and so forth.

### SUMMARY

Some embodiments of the present inventive concepts provide a semiconductor memory device having improved electrical properties and increased integration.

The object of the present inventive concepts is not limited to the mentioned above, and other objects which have not been mentioned above will be clearly understood to those skilled in the art from the following description.

According to an aspect of the present disclosure, a semiconductor memory device includes a bit line disposed on a semiconductor substrate and extending in a first direction parallel to a top surface of the semiconductor substrate, a word line disposed on the semiconductor substrate and extending in a second direction parallel to the top surface of the semiconductor substrate and orthogonal to the first direction, a first mold dielectric pattern and a second mold dielectric pattern overlapping the bit line and extending parallel to the word line, the first and second mold dielectric patterns being sequentially stacked in a third direction perpendicular to the first and second directions, a first metal oxide pattern including a first part disposed between the word line and a top surface of the bit line and a second part disposed between the word line and a lateral surface of the first mold dielectric pattern, a second metal oxide pattern contacting a lateral surface of the second mold dielectric pattern, and a channel pattern disposed between the first metal oxide pattern and the word line and contacting a bottom surface of the second mold dielectric pattern and a bottom surface of the second metal oxide pattern. According to an aspect of the present disclosure, a semiconductor memory device includes a bit line disposed on a semiconductor substrate and extending in a first direction parallel to a top surface of the semiconductor substrate, a word line disposed on the semiconductor substrate and extending a second direction parallel to the top surface of the semiconductor substrate and orthogonal to the first direction, a first mold dielectric pattern and a second mold dielectric pattern that overlap the bit line and extend parallel to the word line, the first and second mold dielectric patterns being sequentially stacked in a third direction perpendicular to the first and second directions, a first metal oxide pattern that covers a portion of a top surface of the bit line and contacts a lateral surface of the first mold dielectric pattern, a second metal oxide pattern contacting a lateral surface of the second mold dielectric pattern, a channel pattern disposed between the word line and the first metal oxide pattern and contacting a bottom surface of the second mold dielectric pattern and a bottom surface of the second metal oxide pattern, and a landing pad connected to the channel pattern. The landing pad contacts a lateral surface of the second metal oxide pattern and a lateral surface of the channel pattern.

According to an aspect of the present disclosure, a semiconductor memory device includes a bit line that is disposed on a semiconductor substrate and extends in a first direction parallel to a top surface of the semiconductor substrate, a word line that extends in a second direction parallel to the top surface of the semiconductor substrate and orthogonal to the first direction, a first mold dielectric pattern and a second mold dielectric pattern that overlap the bit line and extend parallel to the word line, the first and second mold dielectric patterns being sequentially stacked on each other in a third direction perpendicular to the first and second directions, a first metal oxide pattern including a first part disposed between the word line and a top surface of the bit line and a second part disposed between the word line and a lateral surface of the first mold dielectric pattern, a second metal oxide pattern separated from the first metal oxide pattern and contacting a lateral surface of the second mold dielectric pattern, a channel pattern disposed between the first metal oxide pattern and the word line and contacting a bottom surface of the second mold dielectric pattern and a bottom surface of the second metal oxide pattern, a gate dielectric layer disposed between the channel pattern and the word line, a landing pad connected to the channel pattern, and a data storage pattern connected through the landing pad to the channel pattern. A width, in the first direction, of the second mold dielectric pattern is greater than a width, in the first direction, of the first mold dielectric pattern. The landing pad contacts a lateral surface of the second metal oxide pattern and a lateral surface of the channel pattern.

In the various aspects, the first metal oxide pattern and the second metal oxide pattern comprise conductive metal oxides. In some embodiments each of the first and second metal oxide patterns includes at least one selected from: InAlZnO (IAZO), InZnO (IZO), InSnO (ITO). In some embodiments, one or more both of the first and second metal oxide patterns may additionally or alternatively include a different metal oxide.

In the various aspects, the semiconductor memory device comprises the semiconductor substrate.

The first mold dielectric pattern and second mold dielectric pattern may be referred to as the first dielectric pattern and second dielectric pattern, respectively.

In the various aspects, the second mold dielectric pattern is stacked on the first mold dielectric pattern, i.e. so that the second mold dielectric pattern is displaced further from the semiconductor substrate in the third direction than the first mold dielectric pattern.

At least some of the above and other features of the invention are set out in the claims.

### BRIEF DESCRIPTION OF DRAWINGS

FIG. 1 illustrates a block diagram showing a semiconductor memory device according to some embodiments of the present inventive concepts.
FIG. 2 illustrates a perspective view showing a semiconductor memory device according to some embodiments of the present inventive concepts.
FIG. 3 illustrates a plan view showing a semiconductor memory device according to some embodiments of the present inventive concepts.
FIGS. 4A and 4B illustrate cross-sectional views taken along lines A-A', B-B, C-C', and D-D' of FIG. 3, showing a semiconductor memory device according to some embodiments of the present inventive concepts.
FIG. 5 illustrates an enlarged view showing section P of FIG. 4A.
FIGS. 6 to 21 illustrate diagrams showing a method of fabricating a semiconductor memory device according to some embodiments of the present inventive concepts.

### DETAILED DESCRIPTION OF EMBODIMENTS

The following will now describe some embodiments of the present inventive concepts with reference to the accompanying drawings. Like reference numerals may indicate like components throughout the description.

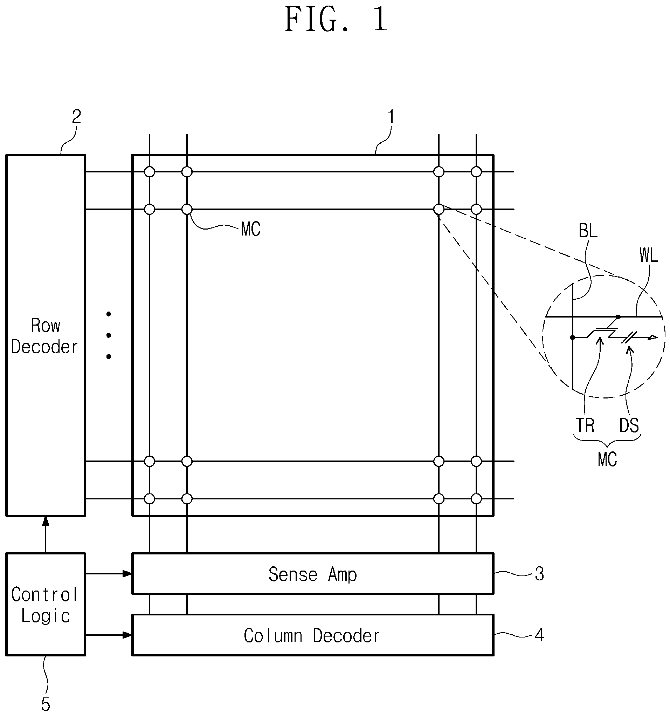

FIG. 1 illustrates a block diagram showing a semiconductor memory device according to some embodiments of the present inventive concepts.

Referring to FIG. 1, a semiconductor memory device may include a memory cell array 1, a row decoder 2, a sense amplifier 3, a column decoder 4, and a control logic 5.

The memory cell array 1 may include a plurality of memory cells MC that are arranged two-dimensionally or three-dimensionally. Each of the memory cells MC may be connected to a corresponding word line of word lines WL and a corresponding bit line of bit lines BL that cross each other. In some embodiments, each of the memory cells MC may be located at a region where the corresponding word line and the corresponding bit line cross each other.

Each of the memory cells MC may include a selection element TR and a data storage element DS, and the selection element TR and the data storage element DS may be electrically connected with each other in series. The selection element TR may be connected between the data storage element DS and the word line WL, and the data storage element DS may be connected through the selection element TR to the bit line BL. The selection element TR may be a field effect transistor (FET), and the data storage element DS may be a capacitor, a magnetic tunnel junction pattern, or a variable resistor. For example, the selection element TR may include a transistor, a gate electrode of the transistor may be connected to the word line WL, and source/drain terminals of the transistor may be connected to the bit line BL and the data storage element DS.

The row decoder 2 may decode an address that is externally input, and may select one of the word lines WL of the memory cell array 1. The address that is decoded in the row decoder 2 may be provided to a row driver (not shown), and in response to a control operation of control circuits, the row driver may provide a certain voltage to a selected word line WL and each of non-selected word lines WL.

In response to an address that is decoded from the column decoder 4, the sense amplifier 3 may detect and amplify a voltage difference between a selected bit line BL and a reference bit line, and may then output the amplified voltage difference.

The column decoder 4 may provide a data delivery pathway between the sense amplifier 3 and an external device (e.g., a memory controller). The column decoder 4 may decode an address that is externally input and may select one of the bit lines BL.

The control logic 5 may generate control signals that control operations to write data to the memory cell array 1 and/or to read data from the memory cell array 1.

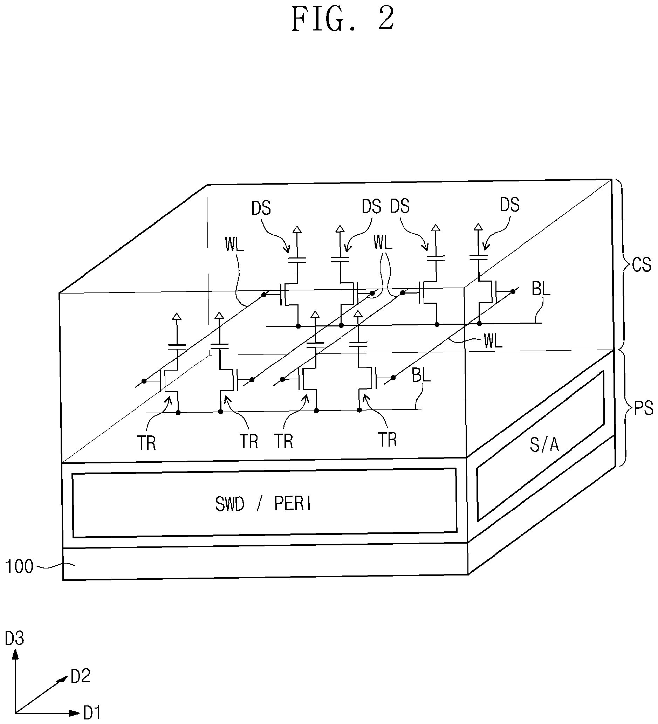

FIG. 2 illustrates a perspective view showing a semiconductor memory device according to some embodiments of the present inventive concepts.

Referring to FIG. 2, a semiconductor memory device may include a peripheral circuit structure PS on a semiconductor substrate 100, and a cell array structure CS on the peripheral circuit structure PS. For example, the peripheral circuit structure PS may be positioned between the semiconductor substrate 100 and the cell array structure CS in a third direction D3 perpendicular to a top surface of the semiconductor substrate 100.

The peripheral circuit structure PS may include core/peripheral circuits that are formed on the semiconductor substrate 100. The core/peripheral circuits may include the row decoder, the column decoder, the sense amplifier, and the control logic of FIG. 1.

The cell array structure CS may include bit lines BL, word lines WL, and the memory cells MC of FIG. 1 between the bit lines BL and the word lines WL. The memory cells MC of FIG. 1 may be arranged two-dimensionally or three-dimensionally on a plane defined by a first direction D1 and a second direction D2. Each of the memory cells MC of FIG. 1 may include a selection element TR and a data storage element DS.

For example, the selection element TR may include a vertical channel transistor (VCT). A channel of the vertical channel transistor may have a shape that extends in a direction (e.g., the third direction D3) perpendicular to the top surface of the semiconductor substrate 100. The data storage element DS may be a capacitor.

The present inventive concepts, however, are not limited thereto. The semiconductor memory device may include the cell array structure CS on the semiconductor substrate 100, and may also include the peripheral circuit structure PS on the cell array structure CS. For example, the cell array structure CS may be positioned between the semiconductor substrate 100 and the peripheral circuit structure PS.

The semiconductor memory device may have a chip-to-chip (C2C) structure. In this description, the C2C structure may refer to a structure in which an upper chip including the cell array structure CS and a lower chip including the peripheral circuit structure PS are connected to each other in a bonding manner. For example, the upper chip and the lower chip may be connected in a hybrid bonding manner. The term "hybrid bonding" may denote that two components including the same material are merged at an interface therebetween.

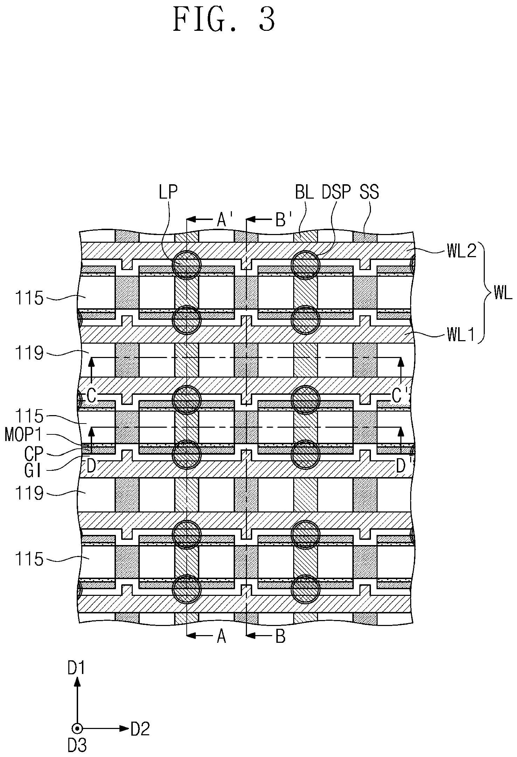

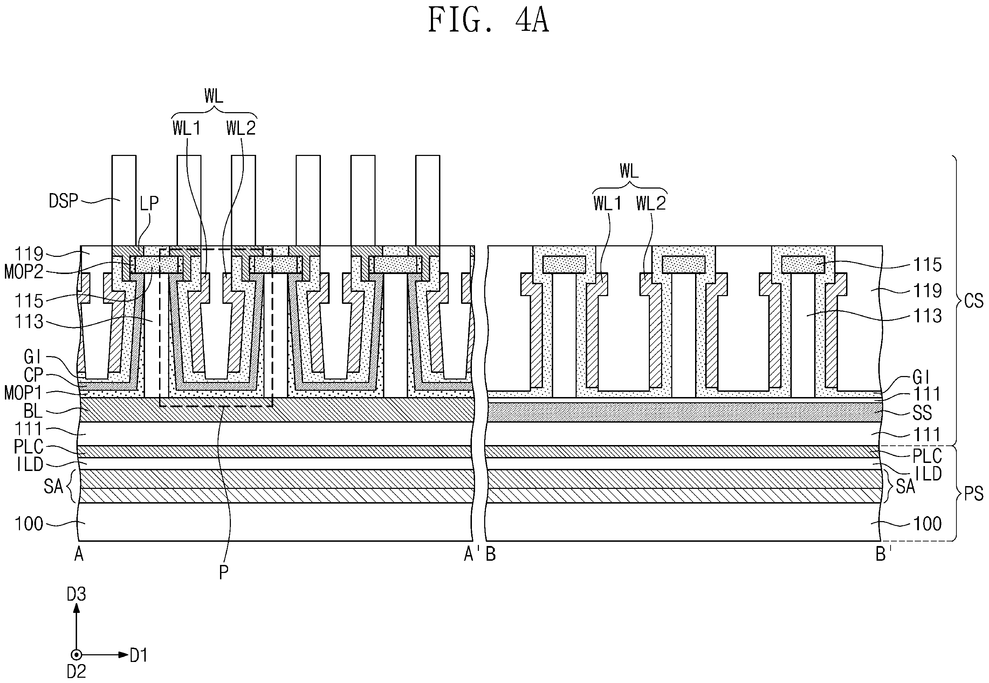

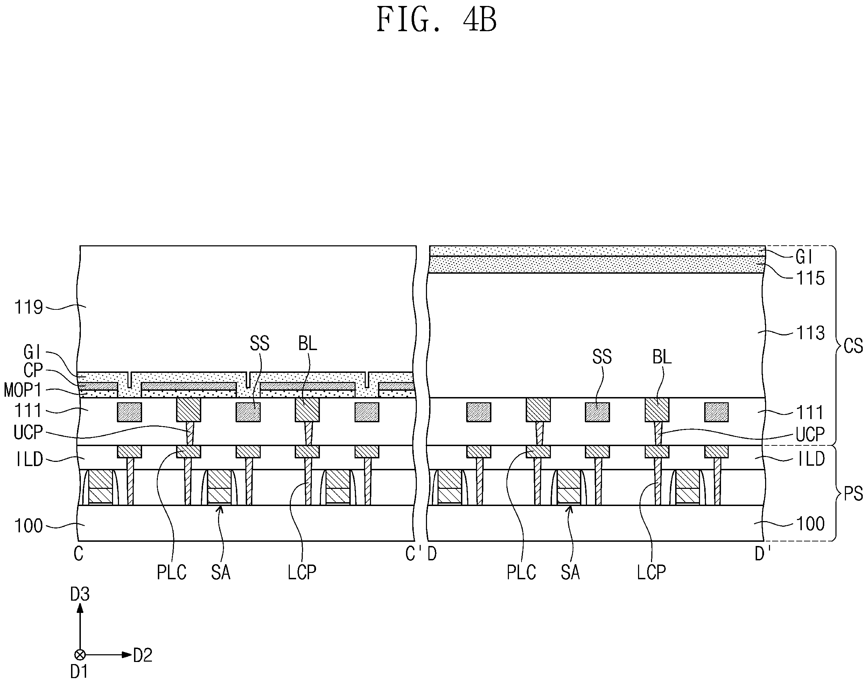

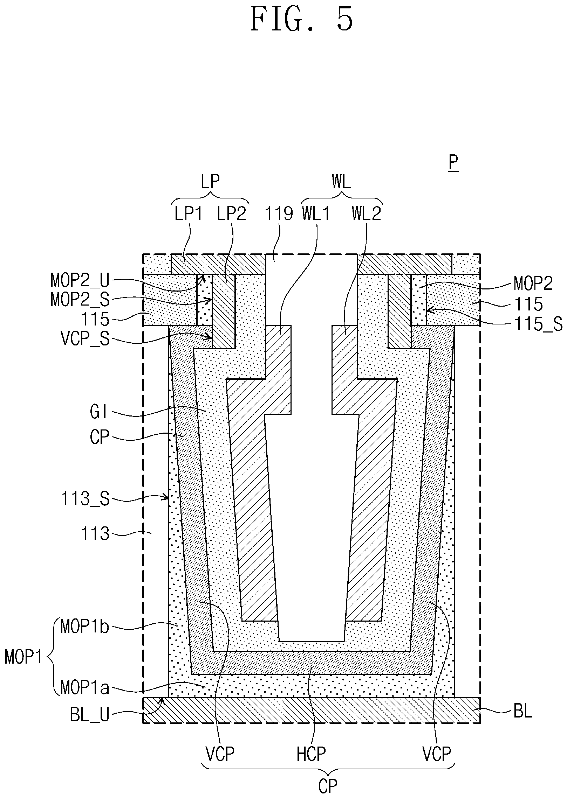

FIG. 3 illustrates a plan view showing a semiconductor memory device according to some embodiments of the present inventive concepts. FIGS. 4A and 4B illustrate cross-sectional views taken along lines A-A', B-B, C-C', and D-D' of FIG. 3, showing a semiconductor memory device according to some embodiments of the present inventive concepts. FIG. 5 illustrates an enlarged view showing section P of FIG. 4A.

Referring to FIGS. 3, 4A, and 4B, a semiconductor memory device according to some embodiments of the present inventive concepts may include a peripheral circuit structure PS and a cell array structure CS on the peripheral circuit structure PS.

The peripheral circuit structure PS may include core circuits SA integrated on a semiconductor substrate 100, lower contact plugs LCP, circuit lines PLC, and a lower dielectric layer ILD that covers the core circuits SA.

The semiconductor substrate 100 may be a monocrystalline silicon substrate, but the present inventive concepts are not limited thereto. A top surface of the semiconductor substrate 100 may be parallel to a first direction D1 and a second direction D2. The top surface of the semiconductor substrate 100 may be perpendicular to a third direction D3.

The core circuits SA may include N-type Metal-Oxide-Semiconductor (NMOS) and P-type Metal-Oxide-Semiconductor (PMOS) transistors integrated on the semiconductor substrate 100. The core circuits SA may be electrically connected through the circuit lines PLC to bit lines BL and word lines WL.

On the semiconductor substrate 100, the lower dielectric layer ILD may cover the core circuits SA, the circuit lines PLC, and the lower contact plugs LCP. The lower contact plugs LCP may be electrically connected to the core circuits SA and the circuit lines PLC. The lower dielectric layer ILD may have a substantially flat top surface. The lower dielectric layer ILD may include or may be formed of, for example, one or more of silicon oxide, silicon nitride, silicon oxynitride, and a low-k dielectric material. In some embodiments, the lower dielectric layer ILD may be formed of multiple layers including different materials from each other.

The cell array structure CS may be positioned on the lower dielectric layer ILD. The cell array structure CS may include bit lines BL, channel patterns CP, word lines WL including first and second word lines WL1 and WL2, a gate dielectric layer GI, landing pads LP, and data storage patterns DSP.

On the lower dielectric layer ILD, the bit lines BL may extend in the first direction D1 and may be spaced apart from each other in the second direction D2.

For example, the bit lines BL may include or may be formed of doped polysilicon, metal, conductive metal nitride, conductive metal silicide, conductive metal oxide, or any combination thereof. The bit lines BL may be formed of a single layer or multiple layers. The bit lines BL may include or may be formed of a carbon-based two-dimensional material such as graphene, a carbon-based three-dimensional material such as carbon nano-tube, or any combination thereof.

An interlayer dielectric pattern 111 may be provided on the lower dielectric layer ILD. The interlayer dielectric pattern 111 may cover the top surface of the lower dielectric layer ILD. The interlayer dielectric pattern 111 may be positioned between the bit lines BL and the circuit lines PLC. The interlayer dielectric pattern 111 may be provided therein with upper contact plugs UCP that connect the bit lines BL to the circuit lines PLC. For example, the interlayer dielectric pattern 111 may include or may be formed of one or more of silicon oxide, silicon nitride, silicon oxynitride, and a low-k dielectric material.

The interlayer dielectric pattern 111 may be provided with shield structures SS therein. Each of the shield structures SS may be positioned between neighboring bit lines BL. Each of the shield structures SS may extend in the first direction D1. The shield structures SS may be spaced apart from each other in the second direction D2. The shield structures SS may have their top surfaces located at a level (height) lower than that of top surfaces of the bit lines BL. For example, the shield structures SS may include or may be formed of a conductive material such as metal, and the conductive material may include therein an air gap or a void. The term "air" as discussed herein, may refer to atmospheric air, or other gases that may be present during the manufacturing process.

First and second mold dielectric patterns 113 and 115 may be sequentially stacked on the interlayer dielectric pattern 111 and the bit lines BL. Each of the first and second mold dielectric patterns 113 and 115 may extend in the second direction D2, while extending across the bit lines BL. For example, each of the first and second mold dielectric patterns 113 and 115 may overlap the bit lines BL and extend parallel to the word lines WL.

Each of the second mold dielectric patterns 115 may be in contact with a top surface of a corresponding one of the first mold dielectric patterns 113. A width, in the first direction D1, of the second mold dielectric pattern 115 may be greater than a width, in the first direction D1, of the first mold dielectric pattern 113. For example, the first mold dielectric patterns 113 may include or may be formed of silicon oxide, and the second mold dielectric patterns 115 may include or may be formed of silicon nitride. The term "contact," or "in contact with," as used herein, refers to a direct connection (i.e., physical touching) unless the context indicates otherwise.

Referring to FIGS. 4A and 5, a first metal oxide pattern MOP1 may be positioned on the bit line BL, and may be in contact with a lateral surface 113_S of the first mold dielectric pattern 113. For example, the first metal oxide pattern MOP1 may include a first part MOP1a disposed between the word line WL and the top surface of the bit line BL, and a second part MOPlb disposed between the word line WL and the lateral surface 113_S of the first mold dielectric pattern 113. The first part MOP1a may cover a top surface BL_U of the bit line BL, and contact the lateral surface 113_S of the first mold dielectric pattern 113. The second part MOP1b of the first metal oxide pattern MOP1 may have a shape that extends along the third direction D3 from opposite ends of the first part MOP1a. The second part MOPlb of the first metal oxide pattern MOP1 may cover a portion of the lateral surface 113_S of the first mold dielectric pattern 113. In some embodiments, the first metal oxide pattern MOP1 may be spaced apart from the second mold dielectric pattern 115 without contacting. For example, the second part MOPlb of the first metal oxide pattern MOP1 may be located at a level lower than that of the top surface of the first mold dielectric pattern 113. The second part MOP1b of the first metal oxide pattern MOP1 may be tapered along the third direction D3 and with decreasing distance from the second mold dielectric pattern 115. For example, the second part MOPlb of the first metal oxide pattern MOP1 may have a width in the first direction D1 that decreases with decreasing distance from the second mold dielectric pattern 115 (i.e., a width, in the first direction D1, of the second part MOPlb may decrease toward the second mold dielectric pattern 115).

A channel pattern CP may be disposed between the first metal oxide pattern MOP1 and the word line WL. The channel pattern CP may be disposed on the first metal oxide pattern MOP1 and may be spaced apart from the word line WL. The channel pattern CP may include a horizontal channel part HCP that covers a top surface of the first part MOP1a of the first metal oxide pattern MOP1 and a vertical channel part VCP that covers a lateral surface of the second part MOPlb of the first metal oxide pattern MOP1. The horizontal channel part HCP of the channel pattern CP may be positioned between the first part MOP1a and the word line WL and between the second part MOP1b and the word line WL. The vertical channel part VCP of the channel pattern CP may extend onto the second part MOPlb to contact the lateral surface 113_S of the first mold dielectric pattern 113, a bottom surface of the second mold dielectric pattern 115, and a bottom surface of a second metal oxide pattern MOP2 which will be discussed below.

The first metal oxide patterns MOP1 may be spaced apart from each other in the second direction D2 between the first mold dielectric patterns 113. Likewise, the channel patterns CP may also be spaced apart from each other in the second direction D2 between the first mold dielectric patterns 113. The first metal oxide patterns MOP1 and the channel patterns CP may each have a U-shaped cross section. For example, the channel patterns CP may include indium-gallium-zinc oxide (IGZO). In some embodiments, the channel patterns CP may include or may be formed of an oxide semiconductor. The oxide semiconductor may include InₓGa_{y}Zn_{z}O, InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, InₓGa_{y}O, or any combination thereof. The channel patterns CP may each be formed of a single layer including one oxide semiconductor or multiple layers including different oxide semiconductors. The channel patterns CP may include or may be formed of an amorphous, crystalline, or polycrystalline oxide semiconductor. The channel patterns CP may each have a bandgap energy greater than that of silicon. For example, the channel patterns CP may each have a bandgap energy of about 1.5 eV to about 5.6 eV, and may exhibit desirable channel performance when the bandgap energy is in a range of about 2.0 eV to about 4.0 eV.

The first and second word lines WL1 and WL2 may be positioned on the channel patterns CP. The first and second word lines WL1 and WL2 may extend in the second direction D2, while extending across the bit lines BL and the channel patterns CP. The first and second word lines WL1 and WL2 may be alternately arranged along the first direction D1. For example, a pair of first and second word lines WL1 and WL2 may be positioned at a corresponding channel pattern of the channel patterns CP.

The first and second word lines WL1 and WL2 may include or may be formed of, for example, doped polysilicon, metal, conductive metal nitride, conductive metal silicide, conductive metal oxide, or any combination thereof. The first and second word lines WL1 and WL2 may each be formed of a single layer or multiple layers that include different materials from each other. The first and second word lines WL1 and WL2 may include or may be formed of a carbon-based two-dimensional material such as graphene, a carbon-based three-dimensional material such as carbon nano-tube, or any combination thereof.

Upper dielectric patterns 119 may be provided between the first and second word lines WL1 and WL2. Each of the upper dielectric patterns 119 may be positioned between a corresponding pair of first and second word lines WL1 and WL2. Each of the upper dielectric patterns 119 may extend in the second direction D2. The upper dielectric patterns 119 may be spaced apart from each other in the first direction D1. The upper dielectric patterns 119 and the first mold dielectric patterns 113 may be alternately arranged in the first direction D1. The upper dielectric patterns 119 may have their top surfaces which are coplanar with a top surface of the gate dielectric layer GI and top surfaces of the landing pads LP. For example, the upper dielectric patterns 119 may include or may be formed of silicon oxide.

The gate dielectric layer GI may be provided between the channel patterns CP and the first and second word lines WL1 and WL2 and between the channel patterns CP and the upper dielectric patterns 119. The gate dielectric layer GI may be in contact with the first and second word lines WL1 and WL2 and may also be in contact with the channel pattern CP or the upper dielectric pattern 119. The gate dielectric layer GI on the channel patterns CP may extend along inner sidewalls of the channel patterns CP.

The gate dielectric layer GI may include or may be formed of, for example, silicon oxide, silicon oxynitride, a high-k dielectric material of which a dielectric constant is greater than that of silicon oxide, or any combination thereof. The high-k dielectric material may include HfO₂, HfSiO, HfSiON, HfTaO, HfTiO, HfZrO, ZrO₂, Al₂O₃, or any combination thereof, but the present inventive concepts are not limited thereto.

The channel pattern CP may be provided thereon with second metal oxide patterns MOP2 which is in contact with a lateral surface 115_S of the second mold dielectric pattern 115. The second metal oxide patterns MOP2 may be spaced apart from each other along the second direction D2 between the second mold dielectric patterns 115. The second metal oxide patterns MOP2 may be formed on the channel patterns CP to contact the landing pads LP.

The second metal oxide patterns MOP2 may be spaced apart from and may not be connected to the first metal oxide patterns MOP1. For example, each of the first metal oxide patterns MOP1 may vertically overlap two neighboring second metal oxide patterns MOP2, and may be separated from the two neighboring second metal oxide patterns MOP2. In some embodiments, each of the first metal oxide patterns MOP may have a U-shape pattern, and a distance, in the first direction, between upper ends of the U-shaped first metal oxide pattern may be greater than a distance, in the first direction, between two neighboring second metal oxide patterns which vertically overlap the U-shaped first metal oxide pattern. As the first and second metal oxide patterns MOP1 and MOP2 are not connected with each other, the first and second metal oxide patterns MOP1 and MOP2 may not act as channels such as the channel patterns CP. The first and second metal oxide patterns MOP1 and MOP2 may include or may be formed of at least one selected from InAlZnO (IAZO), InZnO (IZO), InSnO (ITO), and metal oxide. For example, the channel patterns CP may include or may be formed of InGaZnO (IGZO), and the first and second metal oxide patterns MOP1 and MOP2 may include or may be formed of a material different from the material (or InGaZnO (IGZO)) of the channel patterns CP. When the first and second metal oxide patterns MOP1 and MOP2 include or is formed of InAlZnO (IAZO) or InZnO (IZO), oxygen atoms included in the first and second metal oxide patterns MOP1 and MOP2 may have a bond dissociation energy relatively greater than that of oxygen atoms included in InGaZnO (IGZO) of the channel patterns CP. Thus, an amount of oxidation between the second metal oxide pattern MOP2 and the landing pad LP that are in contact and reacted with each other may be relatively smaller than an amount of oxidation between the channel patterns CP and the landing pad LP that are in contact and reacted with each other. According to some embodiments of the present inventive concepts, it may be possible to reduce an oxidation amount of the landing pad LP of which a portion is in contact with a lateral surface of the second metal oxide pattern MOP2, thereby reducing a contact resistance between the landing pad LP and the channel pattern CP.

The landing pads LP may each be positioned on a corresponding one of the first and second word lines WL1 and WL2. The landing pads LP may be in contact with the channel patterns CP, the second mold dielectric patterns 115, and the second metal oxide patterns MOP2. Each of the landing pads LP may have a circular shape when viewed in a plan view, but the present inventive concepts are not limited thereto. For example, each of the landing pads LP may have an oval shape, a rectangular shape, a square shape, a rhombic shape, a hexagonal shape, or any other suitable shapes when viewed in a plan view. The landing pads LP may be spaced apart from each other in the first direction D1 and the second direction D2. The landing pads LP may include or may be formed of, for example, doped polysilicon, metal, conductive metal nitride, conductive metal silicide, conductive metal oxide, or any combination thereof.

The landing pad LP may include a support part LP1 that lies under and serves to support the data storage pattern DSP and a protrusion part LP2 that protrudes vertically (e.g., in the third direction D3) from the support part LP1. The support part LP1 of the landing pad LP may be positioned on the second metal oxide pattern MOP2 and the gate dielectric layer GI. The protrusion part LP2 of the landing pad LP may vertically protrude toward the bit line BL to be disposed between the gate dielectric layer GI and the second metal oxide pattern MOP2 and between the gate dielectric layer GI and the channel pattern CP. For example, the data storage pattern DSP may be disposed on a top surface of the support part LP1, and the protrusion part LP2 may be disposed on a bottom surface of the support part LP1 and may extend from the bottom surface of the support part LP1 toward the bit line BL. For example, the protrusion part LP2 of the landing pad LP may have a lateral surface which is in contact with a lateral surface MOP2_S of the second metal oxide pattern MOP2 and a lateral surface VCP_S of the vertical channel part VCP. According to some embodiments of the present inventive concepts, each of the landing pads LP may be in contact with a lateral surface of the channel pattern CP and the lateral surface MOP2_S of the second metal oxide pattern MOP2, thereby increasing a contact area between the landing pad LP and the channel pattern CP and between the landing pad LP and the second metal oxide pattern MOP2. In addition, as discussed above, the second metal oxide pattern MOP2 may reduce an oxidation amount of the landing pad LP, and a reduced contact resistance may be provided between the channel pattern CP and the landing pad LP and between the second metal oxide pattern MOP2 and the landing pad LP. Accordingly, the semiconductor memory device may improve in electrical properties.

The data storage patterns DSP may be positioned on the landing pads LP. The data storage patterns DSP may be electrically connected through the landing pads LP to the channel patterns CP. When viewed in a plan view, each of the data storage patterns DSP may overlap a corresponding one of the landing pads LP. For example, the data storage patterns DSP may be spaced apart from each other in the first direction D1 and the second direction D2.

For example, the data storage patterns DSP may each be a capacitor. In this case, the data storage patterns DSP may include a bottom electrode, a top electrode, and a dielectric layer between the bottom electrode and the top electrode. The bottom electrode may be in contact with the landing pad LP. In some embodiments, the data storage patterns DSP may each be a variable resistance pattern of which a resistance state can be switched to have one of two resistance states due to an electrical pulse applied to a memory element. In this case, the data storage patterns DSP may include a phase-change material of which a crystalline state is changed based on an amount of current, perovskite compounds, transition metal oxide, magnetic materials, ferromagnetic materials, or antiferromagnetic materials.

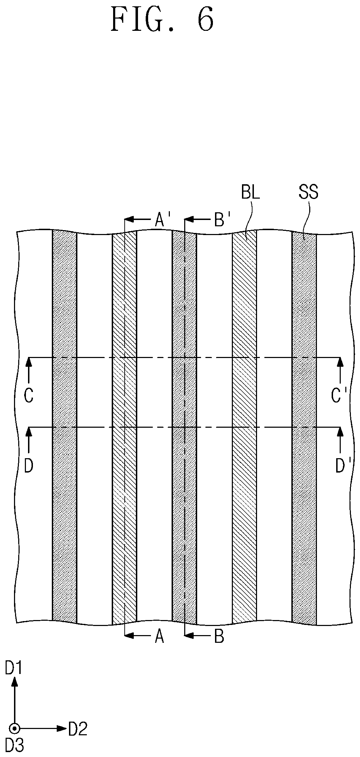

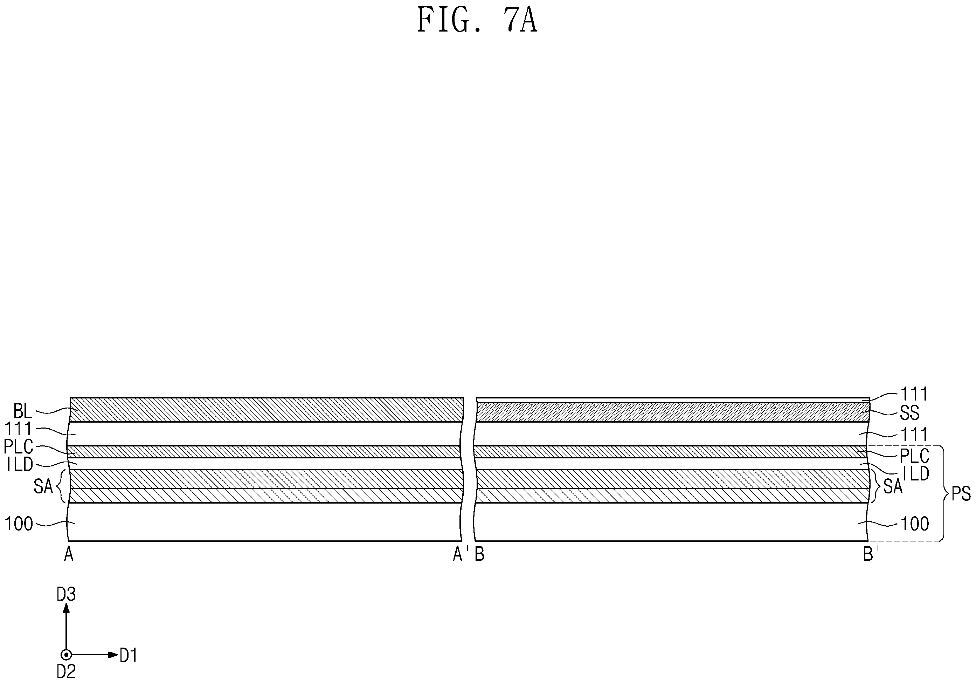

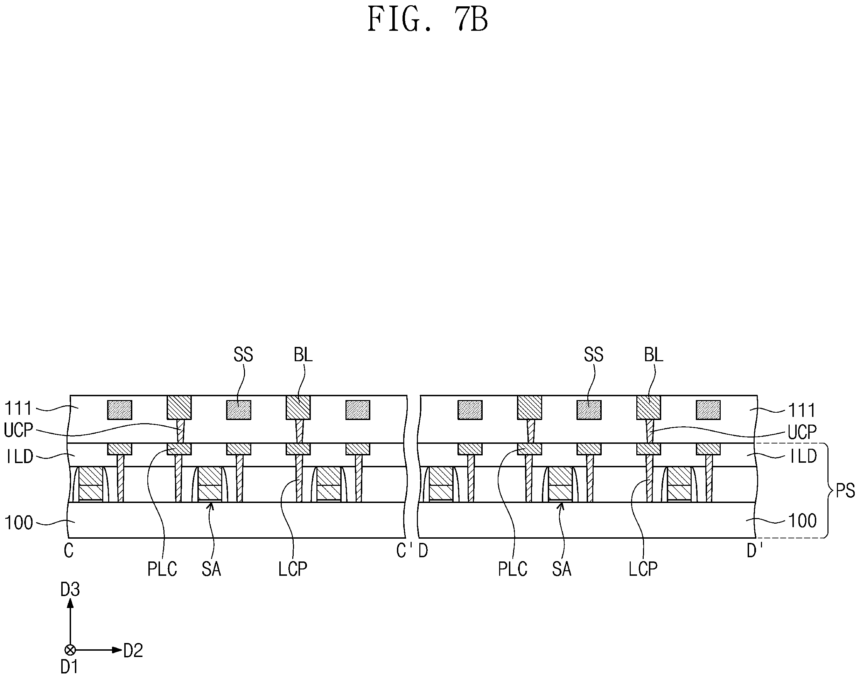

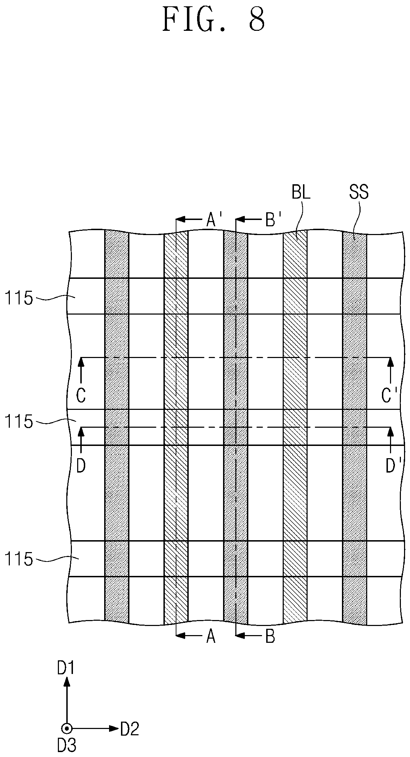

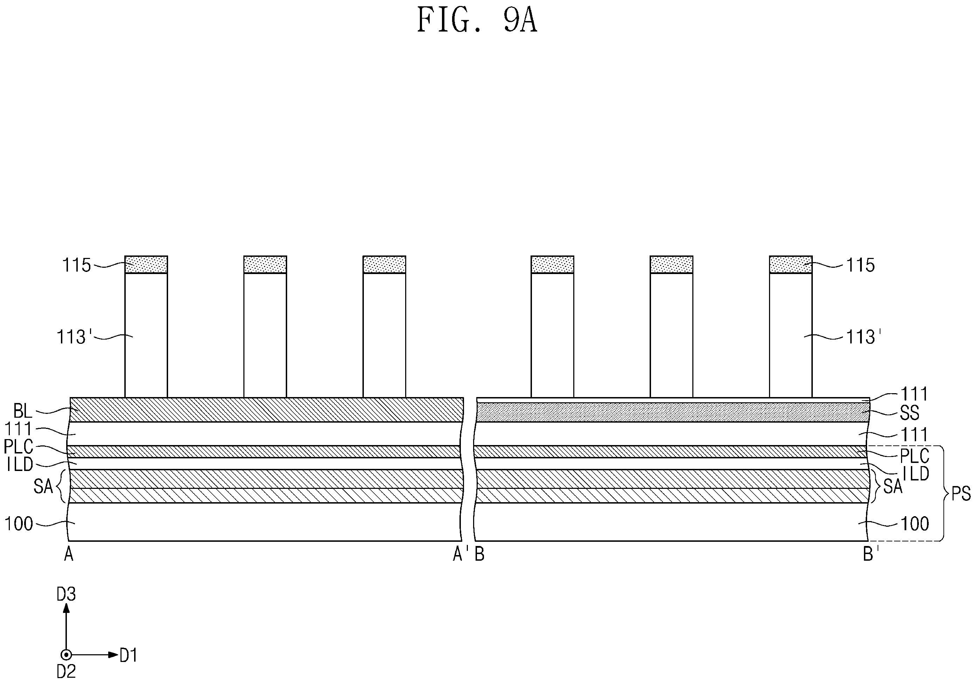

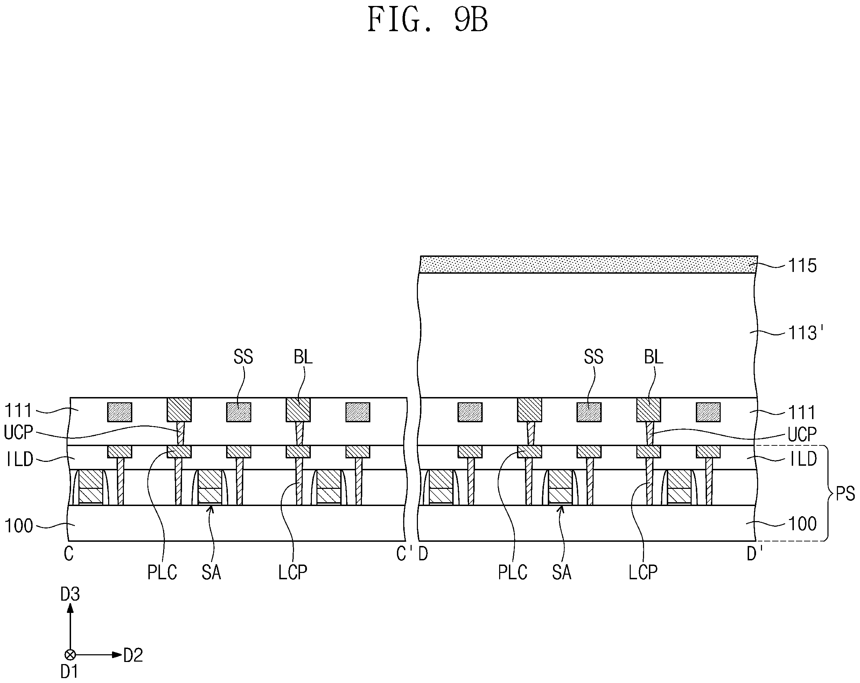

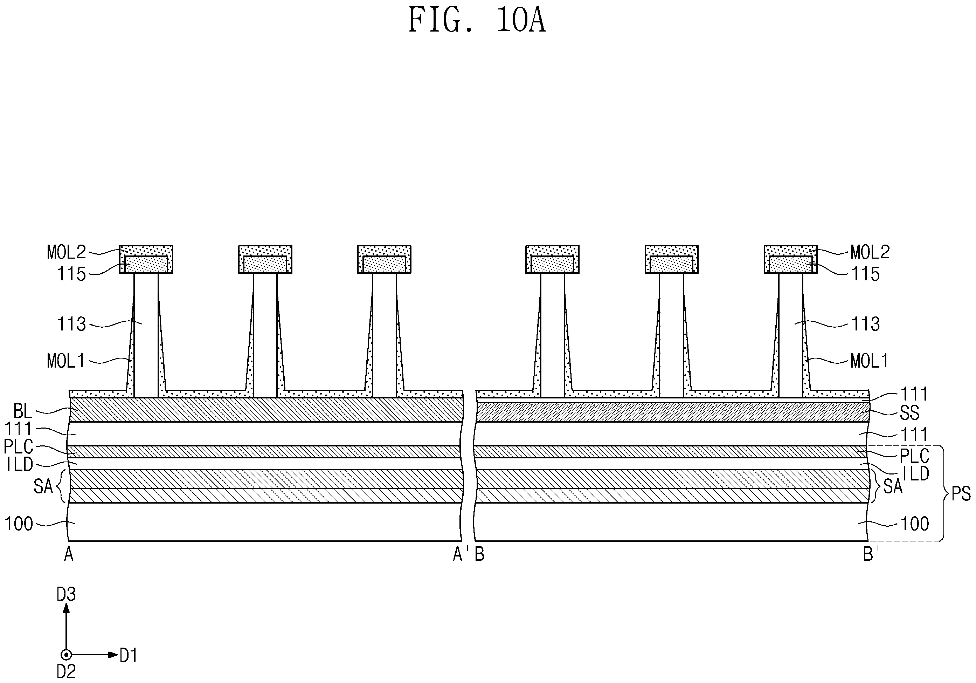

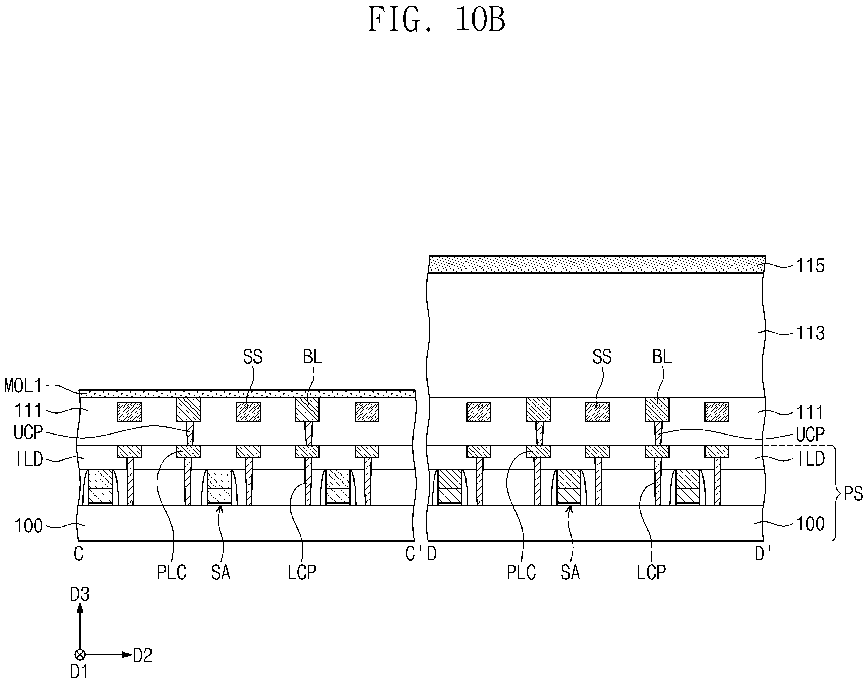

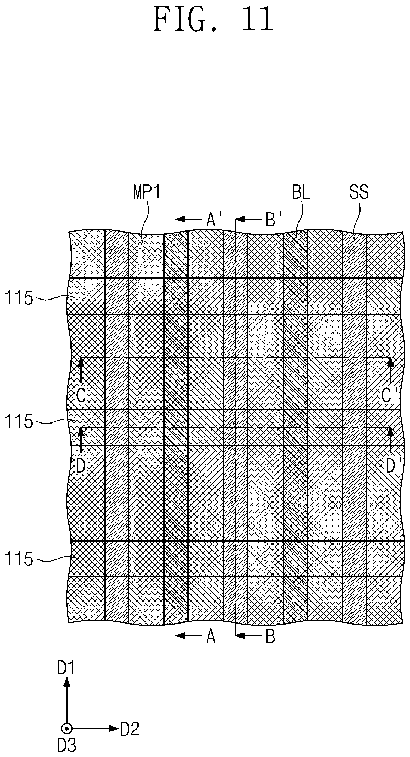

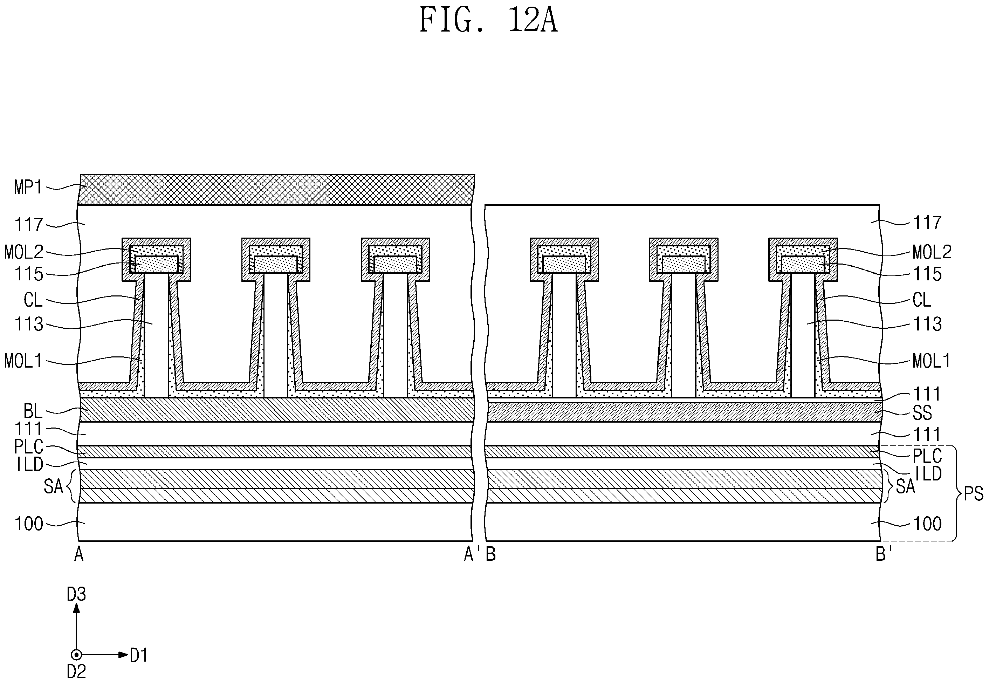

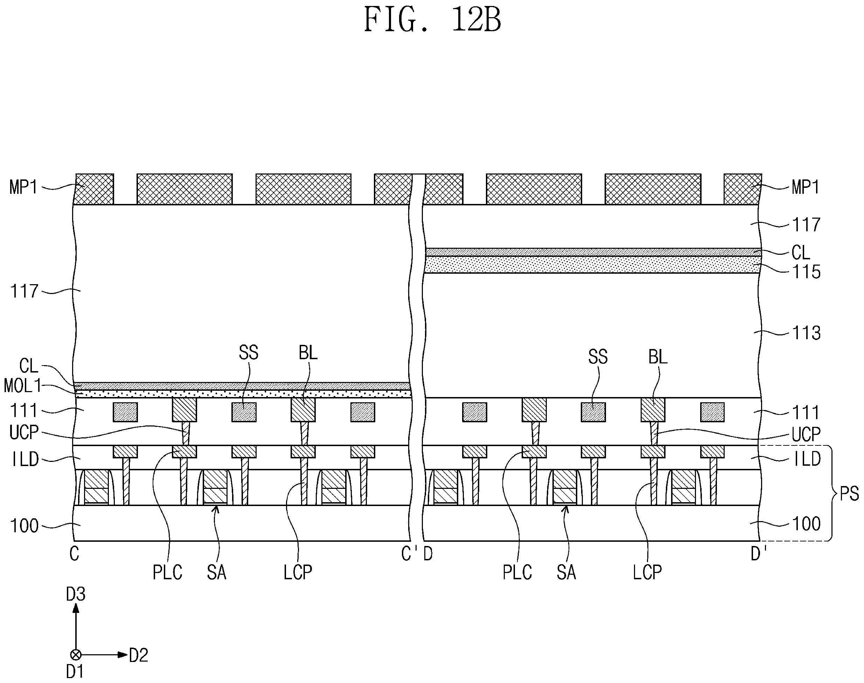

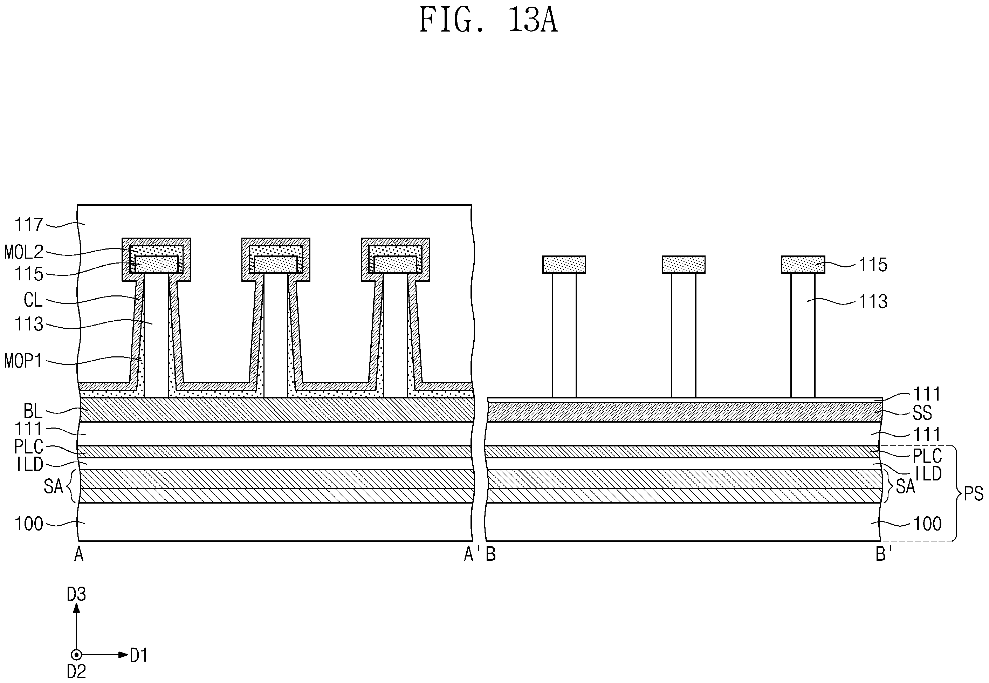

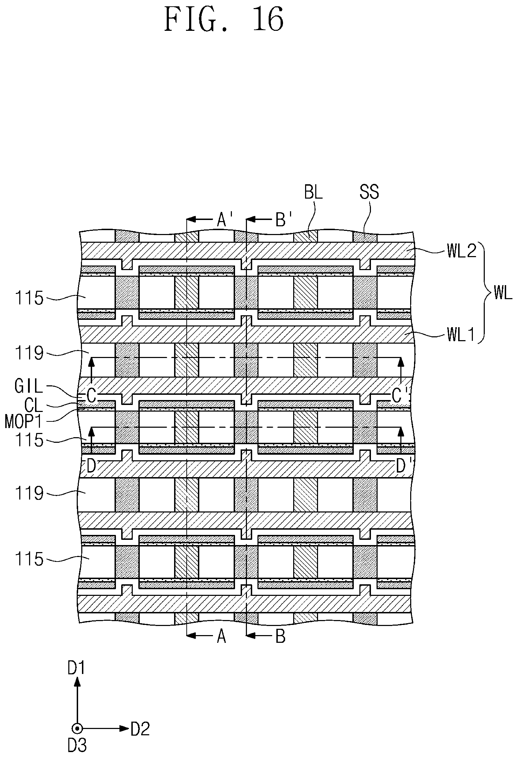

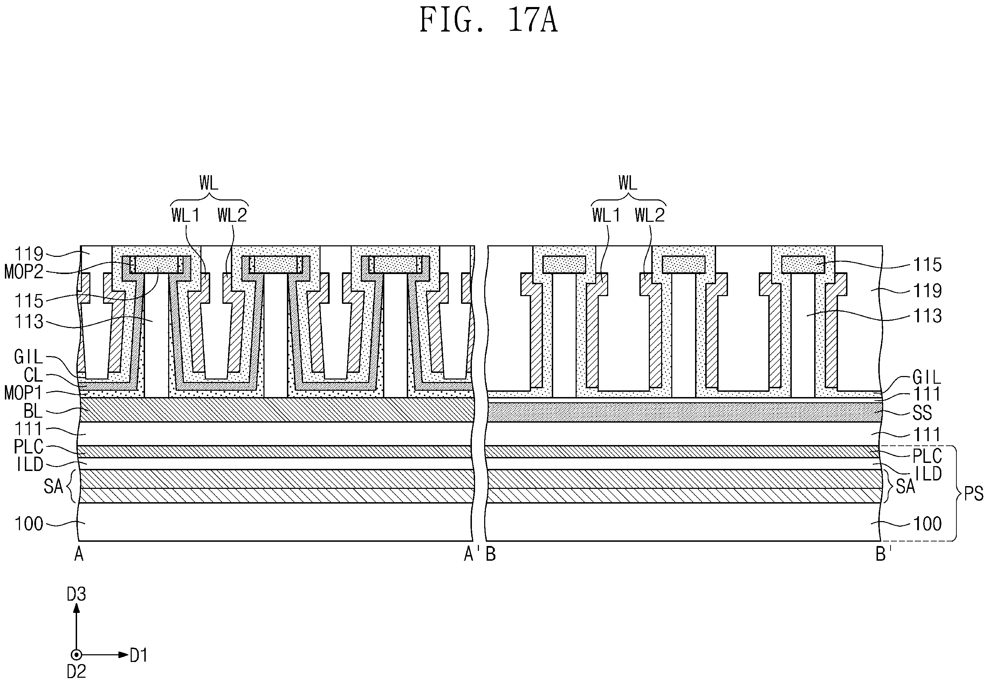

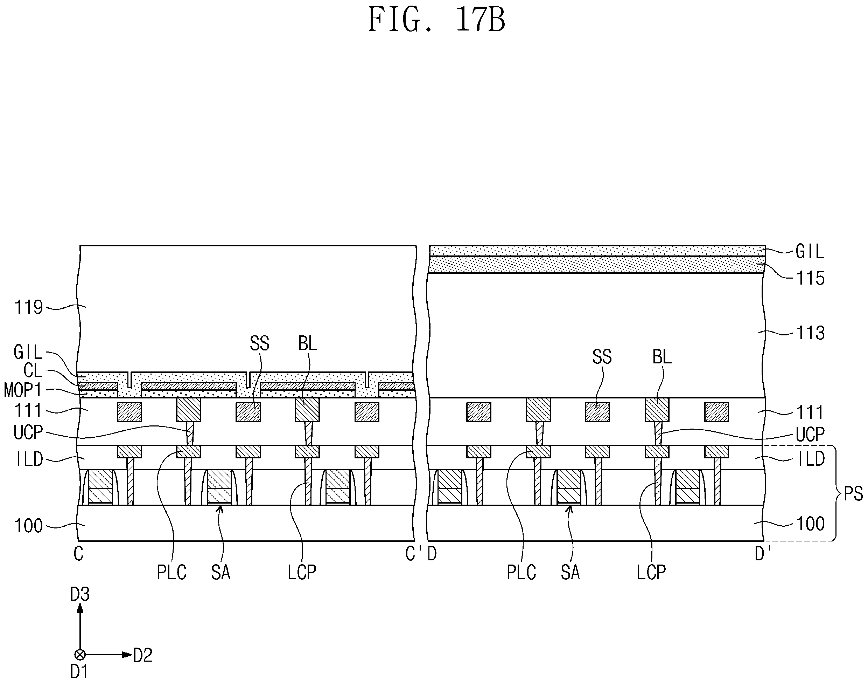

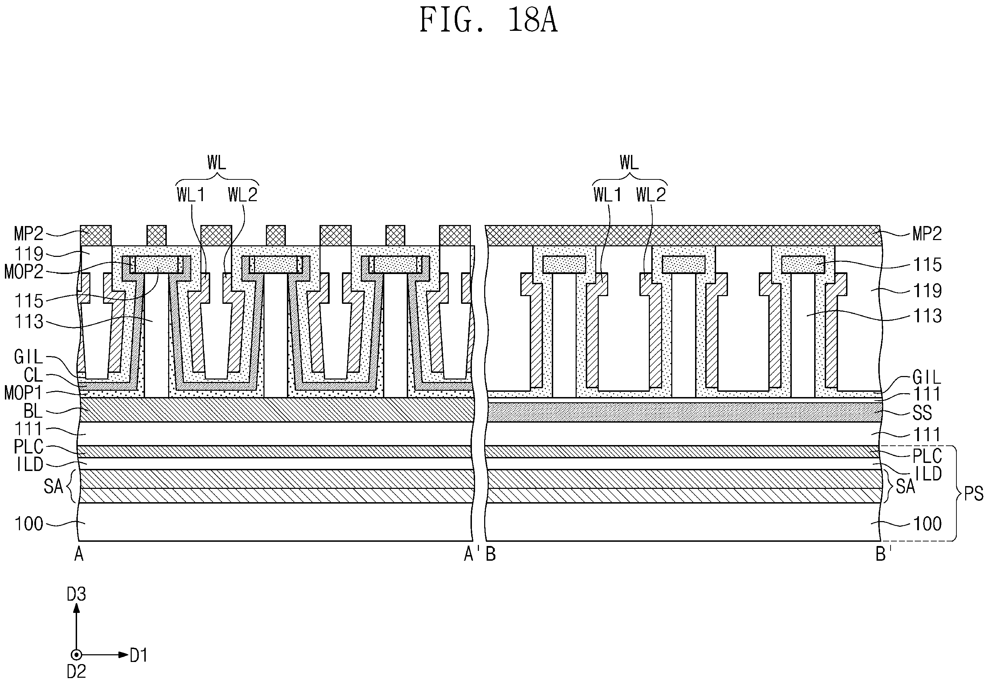

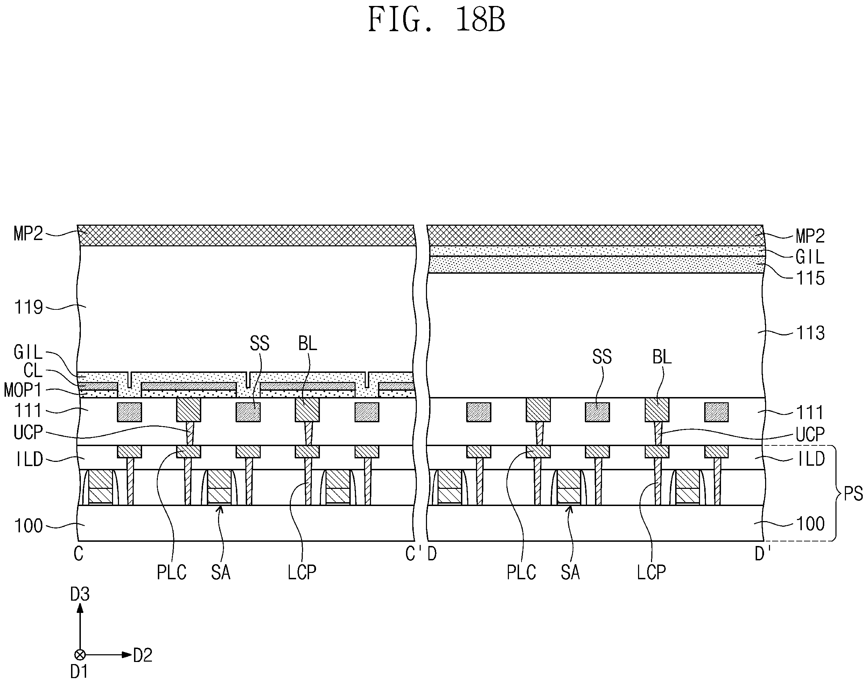

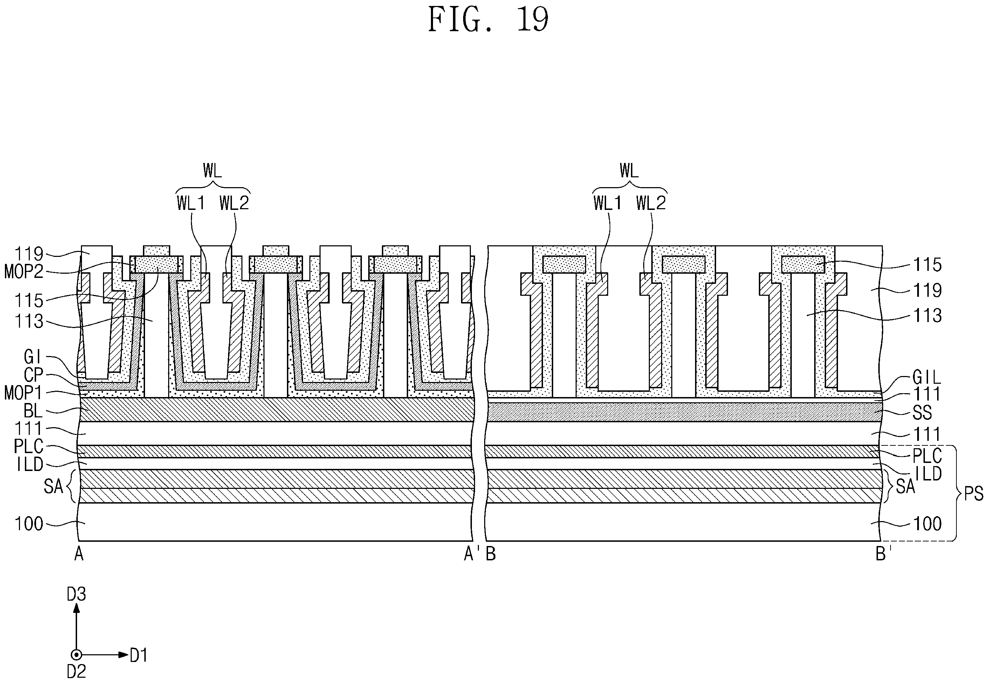

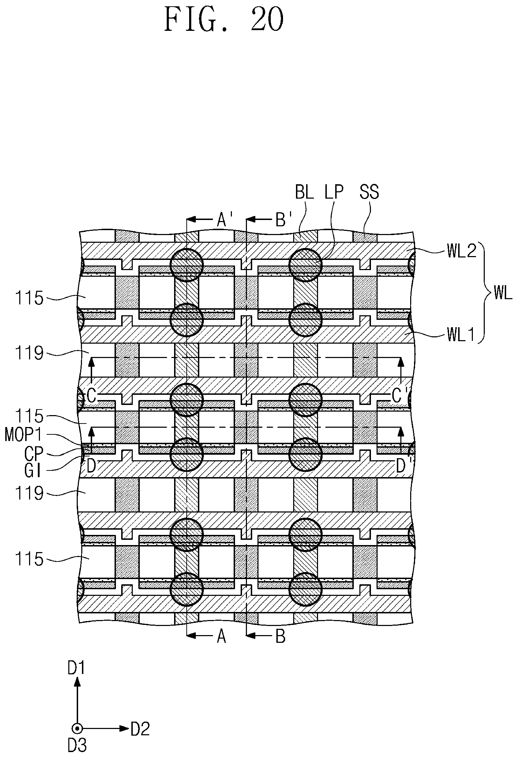

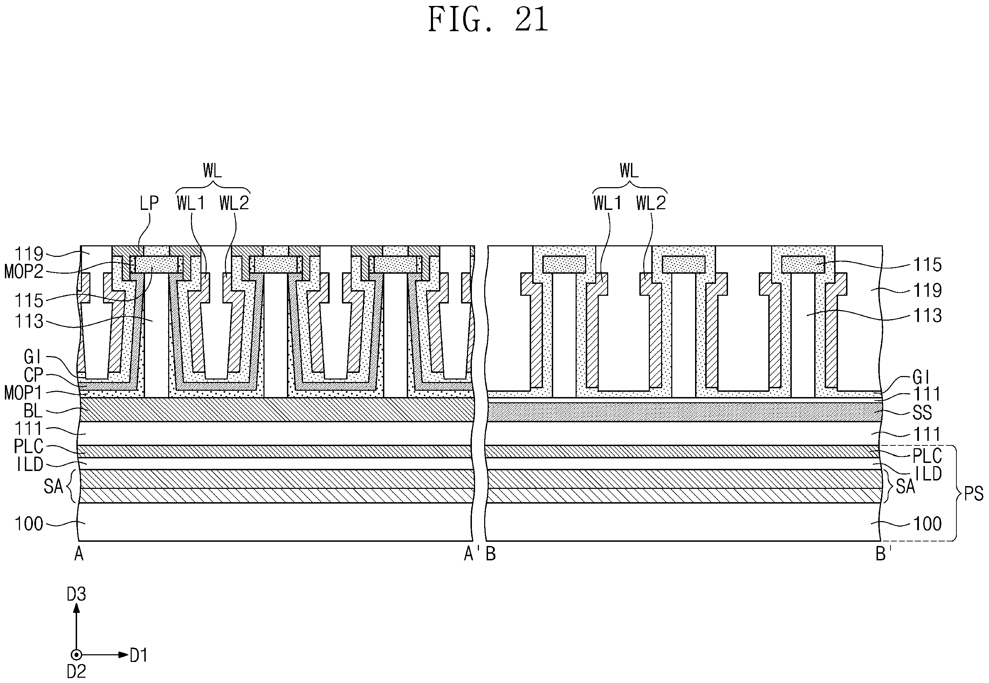

FIGS. 6 to 21 illustrate diagrams showing a method of fabricating a semiconductor memory device according to some embodiments of the present inventive concepts. FIGS. 6, 8, 11, 16, and 20 illustrate plan views showing a semiconductor memory device. FIGS. 7A and 7B illustrate cross-sectional views taken along lines A-A', B-B', C-C', and D-D' of FIG. 6. FIGS. 9A and 9B illustrate cross-sectional views taken along lines A-A', B-B', C-C', and D-D' of FIG. 8. FIGS. 10A and 10B illustrate cross-sectional views taken along lines A-A', B-B', C-C', and D-D' of FIG. 8. FIGS. 12A and 12B illustrate cross-sectional views taken along lines A-A', B-B', C-C', and D-D' of FIG. 11. FIGS. 13A, 13B, 14A, 14B, 15A, and 15B illustrate cross-sectional views taken along lines A-A', B-B', C-C', and D-D' of FIG. 11. FIGS. 17A and 17B illustrate cross-sectional views taken along lines A-A', B-B', C-C, and D-D' of FIG. 16. FIGS. 18A, 18B, and 19 illustrate cross-sectional views taken along lines A-A', B-B', C-C', and D-D' of FIG. 16. FIG. 21 illustrates a cross-sectional view taken along lines A-A' and B-B' of FIG. 20.

Referring to FIGS. 6, 7A, and 7B, a peripheral circuit structure PS including core circuits SA may be formed on a semiconductor substrate 100.

For example, the core circuits SA may be formed on the semiconductor substrate 100, and a lower dielectric layer ILD may be formed to cover the core circuits SA. The lower dielectric layer ILD may include one or more of silicon oxide, silicon nitride, silicon oxynitride, and a low-k dielectric material, and may be formed of a single layer or multiple layers including different materials from each other.

Circuit lines PLC may be formed in the lower dielectric layer ILD, and lower contact plugs LCP may be formed to be connected to the circuit lines PLC. The circuit lines PLC may be electrically connected through the lower contact plugs LCP to the core circuits SA.

Bit lines BL may be formed on the lower dielectric layer ILD. The formation of the bit lines BL may include forming a first interlayer dielectric layer on the lower dielectric layer ILD, forming upper contact plugs UCP to penetrate the first interlayer dielectric layer, depositing a lower conductive layer on the first interlayer dielectric layer, and patterning the lower conductive layer and the first interlayer dielectric layer. The bit lines BL, the first interlayer dielectric layer, and the upper contact plugs UCP may be formed to be spaced apart from each other in a second direction D2.

A second interlayer dielectric layer may be formed on the lower dielectric layer ILD. The second interlayer dielectric layer may have a uniform thickness that covers the bit lines BL and an exposed top surface of the lower dielectric layer ILD. The second interlayer dielectric layer may define gaps positioned between neighboring bit lines BL. Each of the gaps may extend in a first direction D1 parallel to the bit lines BL.

Shield structures SS may be formed to fill the gaps of the second interlayer dielectric layer. Each of the shield structures SS may be positioned between neighboring bit lines BL. The formation of the shield structures SS may include forming on the second interlayer dielectric layer a shield layer that fills the gaps, and recessing a top surface of the shield layer. For example, the shield structures SS may include or may be formed of a metallic material such as W, Ti, Ni, and Co or a conductive two-dimensional (2D) material such as graphene.

The formation of the shield structures SS may be omitted. In this case, spaces between neighboring bit lines BL may be filled with the second interlayer dielectric layer instead of the shield structures SS, but the present inventive concepts are not limited thereto.

Afterwards, an interlayer dielectric pattern 111 may be formed. The formation of the interlayer dielectric pattern 111 may include depositing a dielectric material on the second interlayer dielectric layer and the shield structures SS, and performing a planarization process on the dielectric material and the second interlayer dielectric layer. The planarization process may expose top surfaces of the bit lines BL. The planarization process may not expose top surfaces of the shield structures SS.

Referring to FIGS. 8, 9A, and 9B, preliminary first mold dielectric patterns 113' and second mold dielectric patterns 115 may be formed on the interlayer dielectric pattern 111 and the bit lines BL. The preliminary first mold dielectric patterns 113' and the second mold dielectric patterns 115 may be formed by sequentially stacking a first mold dielectric layer and a second mold dielectric layer on the interlayer dielectric pattern 111 and the bit lines BL, and then patterning the first and second mold dielectric layers. The preliminary first mold dielectric patterns 113' and the second mold dielectric patterns 115 may each extend in the second direction D2 and may be spaced apart from each other in the first direction D1. The preliminary first mold dielectric patterns 113' and the second mold dielectric patterns 115 may expose portions of the bit lines BL. A width in the first direction D1 of the preliminary first mold dielectric patterns 113 may be substantially the same as a width in the first direction D1 of the second mold dielectric patterns 115. Terms such as "same," "equal," "planar," or "coplanar," as used herein encompass near identicality including variations that may occur, for example, due to manufacturing processes. The term "substantially" may be used herein to emphasize this meaning, unless the context or other statements indicate otherwise.

The preliminary first mold dielectric patterns 113' and the second mold dielectric patterns 115 may include different materials from each other. For example, the preliminary first mold dielectric patterns 113' may include or may be formed of silicon oxide, and the second mold dielectric patterns 115 may include or may be formed of silicon nitride.

Referring to FIGS. 8, 10A, and 10B, the preliminary first mold dielectric patterns 113' may be wet etched to form first mold dielectric patterns 113. For example, the first mold dielectric patterns 113 may be formed by providing an etchant, which has etch selectivity with respect to the preliminary first mold dielectric pattern 113 ', to trenches between the preliminary first mold dielectric patterns 113'. A width in the first direction D1 of the first mold dielectric patterns 113 may be less than a width in the first direction D1 of the second mold dielectric patterns 115.

After the wet etching process, a first metal oxide layer MOL1 may be formed to cover lateral surfaces of the first mold dielectric patterns 113 and the top surfaces of the bit lines BL, and a second metal oxide layer MOL2 may be formed to cover top and lateral surfaces of the second mold dielectric patterns 115. The first metal oxide layer MOL1 and the second metal oxide layer MOL2 may be formed by depositing metal oxide on the second mold dielectric patterns 115. The first metal oxide layer MOL1 and the second metal oxide layer MOL2 may be formed by using a thin film deposition method of which step coverage is poor. For example, the first metal oxide layer MOL1 and the second metal oxide layer MOL2 may be formed through physical vapor deposition (PVD) or plasma enhanced chemical vapor deposition (PECVD). However, as the width in the first direction D1 of the second mold dielectric patterns 115 is greater than the width in the first direction D1 of the first mold dielectric patterns 113, metal oxide coated on the second mold dielectric patterns 115 may not entirely cover any the first and second mold dielectric patterns 113 and 115. For example, no metal oxide may be coated on bottom surfaces of the second mold dielectric patterns 115 and portions of the lateral surfaces of the first mold dielectric patterns 113 (e.g., in the vicinity of top ends of the first mold dielectric patterns 113). In such a configuration, the first metal oxide layer MOL1 that covers the lateral surfaces of the first mold dielectric patterns 113 and the top surfaces of the bit lines BL may be spaced apart from the second metal oxide layer MOL2 that covers the top and lateral surfaces of the second mold dielectric patterns 115. The first metal oxide layer MOL1 may be located at a level lower than that of top surfaces of the first mold dielectric patterns 113, and may not be in contact with the bottom surfaces of the second mold dielectric patterns 115.

The first metal oxide layer MOL1 and the second metal oxide layer MOL2 may each include or may be formed of at least one selected from InAlZnO (IAZO), InZnO (IZO), InSnO (ITO), and metal oxide, and the material of the first and second metal oxide layers MOL1 and MOL2 may be different from that (e.g., InGaZnO (IGZO)) of a channel pattern which will be discussed below. For example, as oxygen (O₂) and plasma are essentially used to deposit InGaZnO (IGZO) on the top surfaces of the bit lines BL, the top surfaces of the bit lines BL may be oxidized, and in this procedure, a large amount of heat may be generated. In contrast, according to some embodiments of the present inventive concepts, the first and second metal oxide layers MOL1 and MOL2 may be formed by using physical vapor deposition (PVD) or plasma enhanced chemical vapor deposition (PECVD), and thus it may be possible to reduce the oxidation of the top surfaces of the bit lines BL. Moreover, compared with InGaZnO (IGZO), the first and second metal oxide layers MOL1 and MOL2 may be more stable at high temperature, and thus it may be possible to securely obtain thermal stability during fabrication process.

Referring to FIGS. 11, 12A, and 12B, a channel layer CL may be formed to cover the first mold dielectric patterns 113 and the first and second metal oxide layers MOL1 and MOL2. The channel layer CL may be formed to have a uniform thickness. The channel layer CL may conformally cover the first and second metal oxide layers MOL1 and MOL2, and may also cover exposed portions of the lateral surfaces of the first mold dielectric patterns 113. The channel layer CL may be formed by using thermal chemical vapor deposition (thermal CVD) or atomic layer deposition (ALD). For example, the channel layer CL may include indium-gallium-zinc oxide (IGZO). For example, the channel layer CL may include a semiconductor material, an oxide semiconductor material, or a two-dimensional semiconductor material, or may include silicon, germanium, or silicon-germanium.

A sacrificial layer 117 may be formed on the channel layer CL. The sacrificial layer 117 may have a substantially flat top surface. For example, the sacrificial layer 117 may include one of insulating materials that are formed by using spin-on-glass (SOG) technology and silicon oxide.

Thereafter, a first mask pattern MP1 may be formed on the sacrificial layer 117. The first mask pattern MP1 may have first openings. The first openings of the first mask pattern MP1 may be spaced apart from each other in the second direction D2.

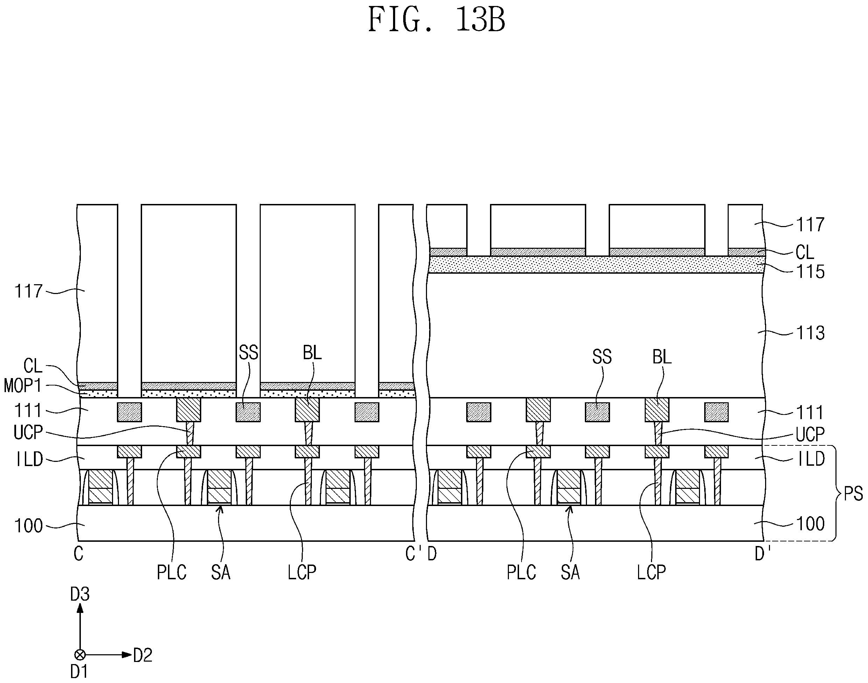

Referring to FIGS. 11, 13A, and 13B, an etching process may be performed using the first mask pattern MP1 as an etching mask. The etching process may partially remove the sacrificial layer 117, the channel layer CL, the first metal oxide layer MOL1, and the second metal oxide layer MOL2, and may partially expose the first and second mold dielectric patterns 113 and 115 and the interlayer dielectric pattern 111. The etching process may separate the first metal oxide layer MOL1, the second metal oxide layer MOL2, and the channel layer CL in the second direction D2 from each other. In the etching process, a portion of the first metal oxide layer MOL1 may be removed to form a first metal oxide pattern MOP1. The first mask pattern MP1 may be separately removed by a subsequent process.

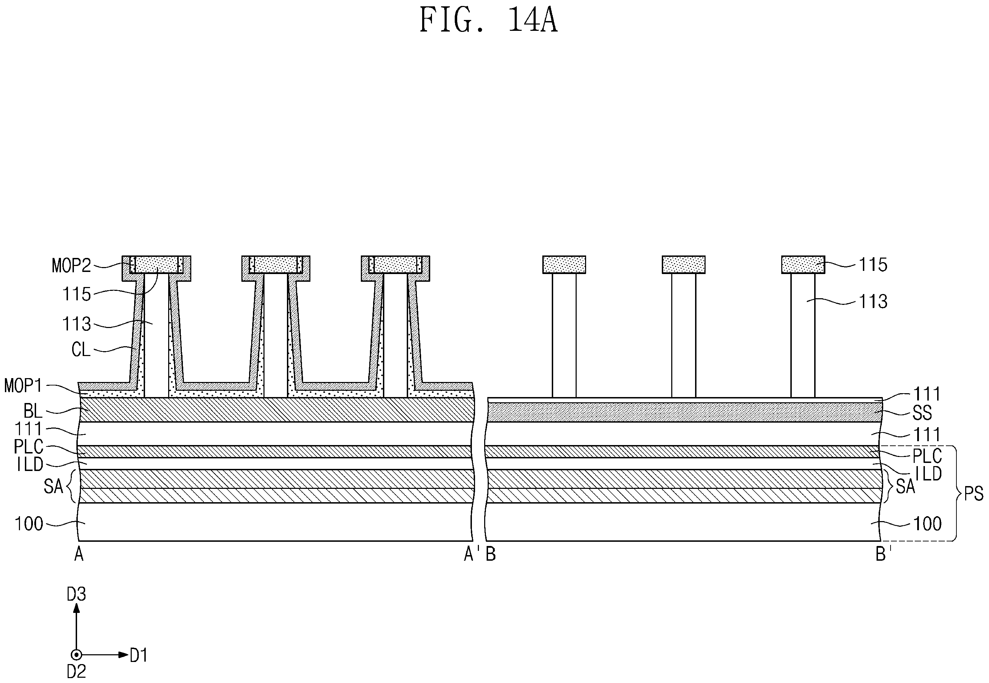

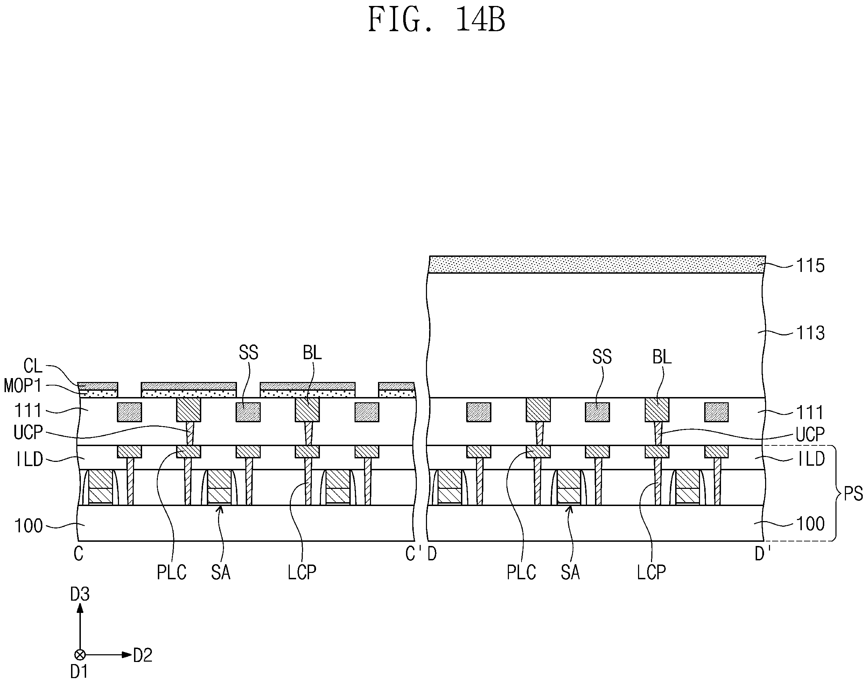

Referring to FIGS. 11, 14A, and 14B, the second metal oxide layer MOL2 and the sacrificial layer 117 may be planarized to expose the top surfaces of the second mold dielectric patterns 115. An upper portion of the second metal oxide layer MOL2 may be partially removed to form a second metal oxide pattern MOP2.

Thereafter, the sacrificial layer 117 may be removed. The sacrificial layer 117 may be removed by using an etching process that has etch selectivity with respect to the first and second mold dielectric patterns 115 and the channel layer CL. Therefore, the channel layer CL may be exposed.

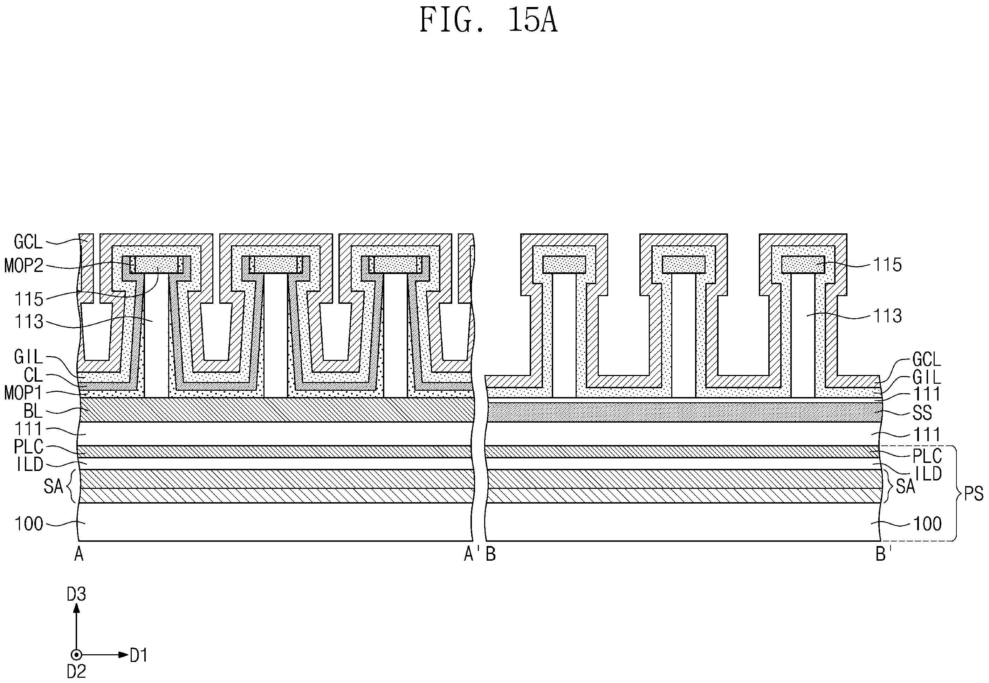

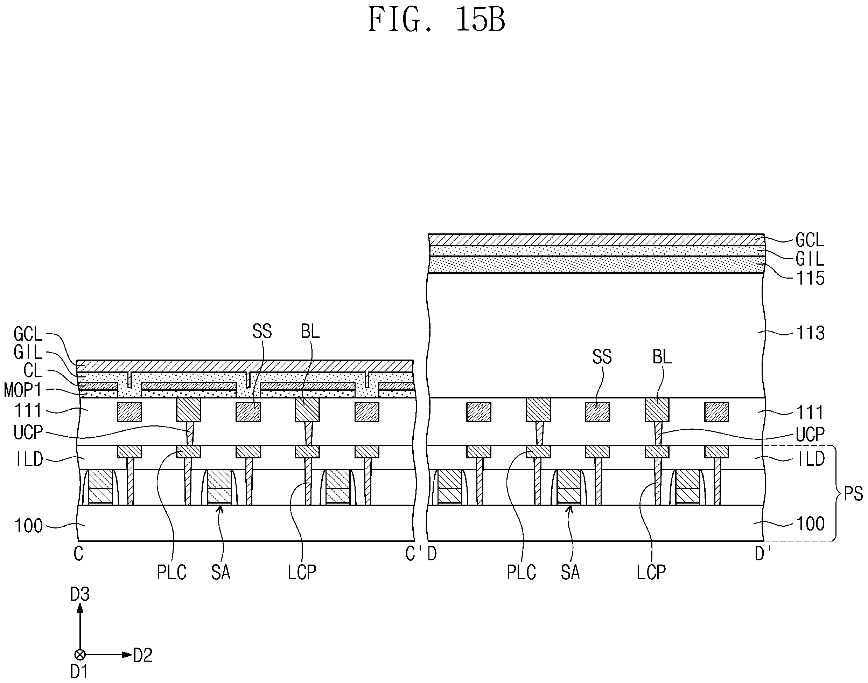

Referring to FIGS. 11, 15A, and 15B, a preliminary gate dielectric layer GIL and a gate conductive layer GCL may be sequentially formed on the channel layer CL. The preliminary gate dielectric layer GIL may have a uniform thickness to cover the channel layer CL, the first and second mold dielectric patterns 113 and 115, and a top surface of the second metal oxide pattern MOP2. The gate conductive layer GCL may have a uniform thickness to cover the preliminary gate dielectric layer GIL. The thickness of the gate conductive layer GCL may be substantially greater than that of the preliminary gate dielectric layer GIL. The preliminary gate dielectric layer GIL and the gate conductive layer GCL may be formed by using at least one selected from physical vapor deposition (PVD), thermal chemical deposition process (thermal CVD), low pressure chemical vapor deposition (LPCVD), plasma enhanced chemical vapor deposition (PECVD), and atomic layer deposition (ALD).

Referring to FIGS. 16, 17A, and 17B, first and second word lines WL1 and WL2 may be formed. The gate conductive layer GCL may undergo an anisotropic etching process to form the first and second word lines WL1 and WL2. The anisotropic etching process may allow the first and second word lines WL1 and WL2 to have their top surfaces lower than that of the channel layer CL.

Then, upper dielectric patterns 119 may be formed between a pair of first and second word lines WL1 and WL2. Each of the upper dielectric patterns 119 may fill a space between the pair of first and second word lines WL1 and WL2. The upper dielectric patterns 119 may have their top surfaces which are coplanar with that of the preliminary gate dielectric layer GIL.

Referring to FIGS. 16, 18A, and 18B, a second mask pattern MP2 may be formed on the preliminary gate dielectric layer GIL and the upper dielectric patterns 119. The second mask pattern MP2 may have second openings. The second openings may be spaced apart from each other in the first direction D1 and the second direction D2. Each of the second openings may have a circular shape when viewed in a plan view, but the present inventive concepts are not limited thereto. The second openings may expose a portion of the top surface of the preliminary gate dielectric layer GIL.

Referring to FIGS. 16 and 19, after the formation of the second mask pattern MP2, an etching process may be performed using the second mask pattern MP2 as an etching mask. The etching process may remove an upper portion of the preliminary gate dielectric layer GIL, and may expose a top surface of the channel layer CL and portions of top surfaces of the second metal oxide patterns MOP2. The upper portion of the preliminary gate dielectric layer GIL may be removed to form a gate dielectric layer GI.

Afterwards, a portion of the channel layer CL may be etched to form channel patterns CP. For example, the channel patterns CP may be formed by performing an anisotropic etching process on the exposed top surface of the channel layer CL. The anisotropic etching process may form trenches between the gate dielectric layer GI and lateral surfaces of the second metal oxide patterns MOP2. The trenches may expose the lateral surfaces of the second metal oxide patterns MOP2 and lateral surfaces of the channel patterns CP. The channel patterns CP may be located at a level lower than that of the second metal oxide patterns MOP2. For example, the channel patterns CP may be lowered than bottom surfaces of the second metal oxide patterns MOP2. In some embodiments, each of the second metal oxide patterns MOP2 may have a bottom surface contacting a top surface of a corresponding one of the channel patterns CP.

Referring to FIGS. 20 and 21, landing pads LP may be correspondingly formed in the trenches. For example, each of the landing pads LP may be formed in a corresponding trench of the trenches. The formation of the landing pads LP may include forming an upper conductive layer to fill the trenches, and planarizing the upper conductive layer to expose a top surface of the gate dielectric layer GI and top surfaces of the upper dielectric patterns 119. The upper conductive layer may cover sidewalls of the second metal oxide patterns MOP2 and sidewalls of the channel patterns CP. For example, the upper conductive layer may include or may be formed of Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or any combination thereof. The landing pads LP may be spaced apart from each other in the first direction D1 and the second direction D2.

Referring to FIGS. 3, 4A, and 4B, data storage patterns DSP may be correspondingly formed on the landing pads LP. For example, each data storage pattern of the data storage patterns DSP may be disposed on a corresponding landing pad of the landing pads LP. When the data storage patterns DSP include capacitors, bottom electrodes, a capacitor dielectric layer, and a top electrode may be sequentially formed. The bottom electrodes may be connected to the landing pads LP, respectively.

In a semiconductor memory device according to some embodiments of the present inventive concepts, a landing pad may be in contact with a lateral surface of a second metal oxide pattern and a lateral surface of a channel pattern. Thus, an increased contact area between the landing pad and the second metal oxide pattern and between the landing pad and the channel pattern, thereby reducing contact resistance between the channel pattern and the landing pad and between the second metal oxide and the landing pad. Accordingly, the semiconductor memory device may improve in electrical properties.

In a semiconductor memory device according to some embodiments of the present inventive concepts, a first metal oxide pattern may be formed on a bit line. The formation of the first metal oxide pattern on the bit line may be more thermally stable than that of a channel pattern on the bit line. Thus, thermal stability may be obtained in fabricating the semiconductor memory device.

Although the present invention has been described in connection with the embodiments of the present invention illustrated in the accompanying drawings, it will be understood to those skilled in the art that various changes and modifications may be made without departing from the essential feature of the present invention. It therefore will be understood that the embodiments described above are just illustrative but not limitative in all aspects.

### ANNEX A

The present invention can also be defined by reference to the following clauses:
Clause 1. A semiconductor memory device, comprising:
   a bit line that extends in a first direction on a semiconductor substrate;
   a word line that extends in a second direction orthogonal to the first direction;
   a first mold dielectric pattern and a second mold dielectric pattern that extend on the bit line and parallel to the word line, the first and second mold dielectric patterns being sequentially stacked along a third direction perpendicular to the first and second directions;
   a first metal oxide pattern between the word line and a top surface of the bit line and between the word line and a lateral surface of the first mold dielectric pattern;
   a second metal oxide pattern in contact with a lateral surface of the second mold dielectric pattern; and
   a channel pattern between the first metal oxide pattern and the word line and in contact with a bottom surface of the second mold dielectric pattern and a bottom surface of the second metal oxide pattern.
Clause 2. The device of clause 1, wherein a width in the first direction of the second mold dielectric pattern is greater than a width in the first direction of the first mold dielectric pattern.
Clause 3. The device of clause 1 or clause 2, wherein the first metal oxide pattern and the second metal oxide pattern are spaced apart from each other.
Clause 4. The device of any of clauses 1 to 3, wherein the first metal oxide pattern includes:
   a first part in contact with a top surface of the bit line; and
   a second part that extends along the third direction from opposite ends of the first part while being in contact with the lateral surface of the first mold dielectric pattern.
Clause 5. The device of clause 4, wherein the second part is at a level lower than a level of a top surface of the first mold dielectric pattern.
Clause 6. The device of clause 4 or clause 5, wherein the second part is tapered along the third direction and with decreasing distance from the second mold dielectric pattern.
Clause 7. The device of any of clauses 4 to 6, wherein the channel pattern includes:
   a horizontal channel part that covers a top surface of the first part; and
   a vertical channel part that covers a lateral surface of the second part,
   wherein a top surface of the vertical channel part is in contact with the bottom surface of the second mold dielectric pattern.
Clause 8. The device of any of clauses 1 to 7, wherein the channel pattern includes InGaZnO (IGZO), and each of the first and second metal oxide patterns includes at least one selected from InAlZnO (IAZO), InZnO (IZO), InTiO (ITO), and metal oxide.
Clause 9. The device of clause 8,
   wherein the first and second metal oxide patterns include the same material selected from InAlZnO (IAZO), InZnO (IZO), InTiO (ITO), and metal oxide.
Clause 10. The device of any of clauses 1 to 9,
   wherein the first mold dielectric pattern includes silicon oxide, and
   the second mold dielectric pattern includes silicon nitride.
Clause 11. The device of any of clauses 1 to 10, further comprising:
   a landing pad in contact with the channel pattern and the second metal oxide pattern; and
   a data storage pattern connected to the landing pad.
Clause 12. A semiconductor memory device, comprising:
   a bit line that extends in a first direction on a semiconductor substrate;
   a word line that extends in a second direction orthogonal to the first direction;
   a first mold dielectric pattern and a second mold dielectric pattern that extend on the bit line and parallel to the word line, the first and second mold dielectric patterns being sequentially stacked along a third direction perpendicular to the first and second directions;
   a first metal oxide pattern that covers a portion of a top surface of the bit line and is in contact with a lateral surface of the first mold dielectric pattern;
   a second metal oxide pattern in contact with a lateral surface of the second mold dielectric pattern;
   a channel pattern between the word line and the first metal oxide pattern and in contact with a bottom surface of the second mold dielectric pattern and a bottom surface of the second metal oxide pattern; and
   a landing pad connected to the channel pattern,
   wherein the landing pad is in contact with a lateral surface of the second metal oxide pattern and a lateral surface of the channel pattern.
Clause 13. The device of clause 12, further comprising a gate dielectric layer between the channel pattern and the word line,
   wherein a portion of the landing pad is between the gate dielectric layer and the second metal oxide pattern.
Clause 14. The device of clause 12 or clause 13, further comprising a data storage pattern on the landing pad,
   wherein the landing pad includes:
      a support part that supports the data storage pattern; and
      a protrusion part that vertically protrudes from the support part,
   wherein a lateral surface of the protrusion part is in contact with the lateral surface of the second metal oxide pattern and the lateral surface of the channel pattern.
Clause 15. The device of any of clauses 12 to 14, wherein a width in the first direction of the second mold dielectric pattern is greater than a width in the first direction of the first mold dielectric pattern.
Clause 16. The device of any of clauses 12 to 15,
   wherein the channel pattern includes InGaZnO (IGZO), and
   each of the first and second metal oxide patterns includes at least one selected from InAlZnO (IAZO), InZnO (IZO), InTiO (ITO), and metal oxide.
Clause 17. The device of any of clauses 12 to 16, wherein the first metal oxide pattern and the second metal oxide pattern are spaced apart from each other.
Clause 18. The device of any of clauses 12 to 17, wherein the channel pattern is spaced apart from the bit line.
Clause 19. A semiconductor memory device, comprising:
   a bit line that extends in a first direction on a semiconductor substrate;
   a word line that extends in a second direction orthogonal to the first direction;
   a first mold dielectric pattern and a second mold dielectric pattern that extend on the bit line and parallel to the word line, the first and second mold dielectric patterns being sequentially stacked along a third direction perpendicular to the first and second directions;
   a first metal oxide pattern between the word line and a top surface of the bit line and between the word line and a lateral surface of the first mold dielectric pattern;
   a second metal oxide pattern spaced apart from the first metal oxide pattern and in contact with a lateral surface of the second mold dielectric pattern;
   a channel pattern between the first metal oxide pattern and the word line and in contact with a bottom surface of the second mold dielectric pattern and a bottom surface of the second metal oxide pattern;
   a gate dielectric layer between the channel pattern and the word line;
   a landing pad connected to the channel pattern; and
   a data storage pattern connected through the landing pad to the channel pattern,
   wherein a width in the first direction of the second mold dielectric pattern is greater than a width in the first direction of the first mold dielectric pattern, and
   wherein the landing pad is in contact with a lateral surface of the second metal oxide pattern and a lateral surface of the channel pattern.
Clause 20. The device of clause 19,
   wherein the channel pattern includes InGaZnO (IGZO), and
   each of the first and second metal oxide patterns includes at least one selected from InAlZnO (IAZO), InZnO (IZO), InTiO (ITO), and metal oxide.

## Claims

1. A semiconductor memory device comprising:
a bit line extending in a first direction parallel to a top surface of a semiconductor substrate;
a word line extending in a second direction parallel to the top surface of the semiconductor substrate and orthogonal to the first direction;
a first mold dielectric pattern and a second mold dielectric pattern overlapping the bit line and extending parallel to the word line, the first and second mold dielectric patterns being sequentially stacked in a third direction perpendicular to the first and second directions;
a first metal oxide pattern including a first part disposed between the word line and a top surface of the bit line and a second part disposed between the word line and a lateral surface of the first mold dielectric pattern;
a second metal oxide pattern contacting a lateral surface of the second mold dielectric pattern; and
a channel pattern disposed between the first metal oxide pattern and the word line and contacting a bottom surface of the second mold dielectric pattern and a bottom surface of the second metal oxide pattern.

2. The device of claim 1,
wherein a width, in the first direction, of the second mold dielectric pattern is greater than a width, in the first direction, of the first mold dielectric pattern.

3. The device of claim 1 or claim 2,
wherein the first metal oxide pattern and the second metal oxide pattern are separated from each other.

4. The device of any preceding claim,
wherein the first part of the first metal oxide pattern contacts the top surface of the bit line,
wherein the second part of the first metal oxide pattern extends along the lateral surface of the first mold dielectric pattern from one of opposite ends of the first part of the first metal oxide pattern, and
wherein the second part of the first metal oxide pattern contacts the lateral surface of the first mold dielectric pattern.

5. The device of claim 4,
wherein the second part of the first metal oxide pattern is lower than a top surface of the first mold dielectric pattern.

6. The device of claim 4 or claim 5,
wherein a width, in the first direction, of the second part of the first metal oxide pattern decreases toward the second mold dielectric pattern.

7. The device of any of claims 4 to 6,
wherein the channel pattern includes:
a horizontal channel part that covers a top surface of the first part of the first metal oxide pattern; and
a vertical channel part that covers a lateral surface of the second part of the first metal oxide pattern, and
wherein a top surface of the vertical channel part contacts the bottom surface of the second mold dielectric pattern.

8. The device of any preceding claim,
wherein the channel pattern includes InGaZnO (IGZO), and
wherein each of the first and second metal oxide patterns includes at least one selected from: InAlZnO (IAZO), InZnO (IZO), InSnO (ITO).

9. The device of claim 8,
wherein the first and second metal oxide patterns include a same material selected from InAlZnO (IAZO), InZnO (IZO), InSnO (ITO).

10. The device of any preceding claim,
wherein the first mold dielectric pattern includes silicon oxide, and
wherein the second mold dielectric pattern includes silicon nitride.

11. The device of any preceding claim, further comprising:
a landing pad contacting the channel pattern and the second metal oxide pattern; and
a data storage pattern connected to the landing pad.

12. The device of any preceding claim,
wherein the first metal oxide pattern covers a portion of the top surface of the bit line and contacts the lateral surface of the first mold dielectric pattern;
wherein the device further comprises a landing pad connected to the channel pattern,
wherein the landing pad contacts a lateral surface of the second metal oxide pattern and a lateral surface of the channel pattern.

13. The device of claim 12, further comprising:
a gate dielectric layer disposed between the channel pattern and the word line,
wherein a portion of the landing pad is disposed between the gate dielectric layer and the second metal oxide pattern.

14. The device of claim 12 or claim 13, further comprising:
a data storage pattern disposed on the landing pad,
wherein the landing pad includes:
a support part having a top surface on which the data storage pattern is disposed; and
a protrusion part that vertically protrudes from a bottom surface of the support part in a direction away from the support part, and
wherein a lateral surface of the protrusion part contacts the lateral surface of the second metal oxide pattern and the lateral surface of the channel pattern.

15. The device of any of claims 12 to 14,
wherein a width, in the first direction, of the second mold dielectric pattern is greater than a width, in the first direction, of the first mold dielectric pattern.
